# EUROPEAN PATENT APPLICATION

(11) **EP 4 839 045 A2**
(43) Date of publication of application: **11.11.2026**
(21) Application number: 26160645.3
(22) Date of filing: 25.02.2026
(51) Int. Cl.: H10D 30/47, H10D 30/01, H10D 64/23, H10D 8/00, H10D 62/17, H10D 62/85, H10D 64/00

(54) **SEMICONDUCTOR DEVICE INCLUDING GATE SPACER**

(30) Priority: 08.05.2025 KR 20250059787
(71) Applicant: Samsung Electronics Co., Ltd., Suwon-si, Gyeonggi-do 16677 (KR)
(72) Inventor: KIM, Joonyong, Suwon-si (KR); KANG, Ju Hui, Suwon-si (KR); KIM, Myeongjin, Suwon-si (KR); KIM, Jongseob, Suwon-si (KR); KIM, Jin-Hwan, Suwon-si (KR); PARK, Junbum, Suwon-si (KR); AHN, Shihyun, Suwon-si (KR); CHOI, Younghwan, Suwon-si (KR)
(74) Representative: Marks & Clerk LLP

(57) **Abstract**

A semiconductor device includes: a channel layer (132); a barrier layer (136) positioned on the channel layer; a gate structure including a gate semiconductor layer (152) positioned on the barrier layer and a gate electrode layer (155) positioned on the gate semiconductor layer; a gate spacer (158) positioned on a side surface of the gate structure; and a source electrode (173) and a drain electrode (175) spaced apart from each other with the gate structure therebetween and each connected to the channel layer, where the source electrode contacts the gate spacer.

## Description

### BACKGROUND

In modern society, semiconductor devices are closely related to daily life. In particular, the importance of power semiconductor devices used in various fields such as transportation sectors including electric vehicles, railways, and electric trams, renewable energy systems like solar power and wind power, and mobile devices is gradually increasing. Power semiconductor devices, as semiconductor devices used to handle high voltage or high current, perform functions such as power conversion and control in large power systems or high-power electronic devices. Power semiconductor devices have the capability and durability to handle high power, allowing them to manage large currents and withstand high voltage. For example, power semiconductor devices can handle voltage ranging from hundreds of volts to thousands of volts and current from tens of amperes to thousands of amperes. Power semiconductor devices may minimize power loss to enhance the efficiency of electrical energy. Furthermore, power semiconductor devices can stably operate even in environments such as high temperatures.

### SUMMARY

In some examples, power semiconductor devices may be classified according to the material. For instance, there are silicon carbide (SiC) power semiconductor devices and gallium nitride (GaN) power semiconductor devices. By using SiC or GaN instead of the existing silicon wafer (Si wafer), the disadvantages of silicon, which has unstable characteristics at high temperatures, may be compensated. SiC power semiconductor devices may be resistant to high temperatures and may have low power loss, making them suitable for electric vehicles and renewable energy systems. GaN power semiconductor devices may be efficient in terms of speed, making them suitable for high-speed charging of mobile devices.

The present disclosure provides a stable semiconductor device with low resistance by easily adjusting the capacitance between the gate electrode layer and the source electrode, minimizing the gap between the gate electrode layer and the source electrode, and resolving the resulting misalignment issues of the source electrode.

An aspect of the present disclosure provides a semiconductor device including a channel layer, a barrier layer positioned on the channel layer, a gate structure including a gate semiconductor layer positioned on the barrier layer and a gate electrode layer positioned on the gate semiconductor layer, a gate spacer positioned on a side surface of the gate structure, and a source electrode and a drain electrode spaced apart from each other with the gate structure therebetween and each connected to the channel layer, where the source electrode contacts with the gate spacer.

Another aspect of the present disclosure provides a semiconductor device including a channel layer, a barrier layer positioned on the channel layer, a gate structure including a gate semiconductor layer positioned on the barrier layer, a gate electrode layer positioned on the gate semiconductor layer, a second hard mask layer positioned on the gate electrode layer, and a first hard mask layer positioned on the second hard mask layer, a gate spacer positioned on a side surface of the gate structure, and a source electrode and a drain electrode spaced apart from each other with the gate structure therebetween and each connected to the channel layer, where the first hard mask layer and the gate structure include materials having different etch selectivities, and the first hard mask layer and the second hard mask layer include materials having different etch selectivities.

Another aspect of the present disclosure provides a semiconductor device including a channel layer, a barrier layer positioned on the channel layer, a gate structure including a gate semiconductor layer positioned on the barrier layer, a gate electrode layer positioned on the gate semiconductor layer, and a first hard mask layer positioned on the gate electrode layer, a gate spacer positioned on a side surface of the gate structure, and a source electrode and a drain electrode spaced apart from each other with the gate structure therebetween and each connected to the channel layer, where the first hard mask layer and the gate spacer include materials with different etch selectivities, and where the first hard mask layer includes a metal material.

At least some of the above and other features of the invention are set out in the claims.

### BRIEF DESCRIPTION OF THE DRAWINGS

Fig. 1 is a plan view illustrating an example of a semiconductor device.
Fig. 2 is a cross-sectional view taken along line A-A' of Fig. 1.
Fig. 3 is a cross-sectional view enlarging the P portion of Fig. 2.
Fig. 4 is a cross-sectional view enlarging the P portion of Fig. 2, illustrating another example.
Fig. 5 is a cross-sectional view enlarging the P portion of Fig. 2, illustrating another example.
Fig. 6 is a cross-sectional view enlarging the P portion of Fig. 2, illustrating another example.
Fig. 7 is a cross-sectional view enlarging the P portion of Fig. 2, illustrating another example.
Fig. 8 is a cross-sectional view enlarging the P portion of Fig. 2, illustrating another example.
Fig. 9 is a cross-sectional view enlarging the P portion of Fig. 2, illustrating another example.
Fig. 10 is a cross-sectional view enlarging the P portion of Fig. 2, illustrating another example.
Fig. 11 is a cross-sectional view enlarging the P portion of Fig. 2, illustrating another example.
Fig. 12 is a cross-sectional view enlarging the P portion of Fig. 2, illustrating another example.
Fig. 13 is a cross-sectional view taken along line A-A' of Fig. 1, illustrating another example.
Figs. 14 to 24 are cross-sectional views illustrating a method of manufacturing an example of a semiconductor device in process order.

### DETAILED DESCRIPTION

Hereinafter, various implementations of the present disclosure will be described in detail with reference to the attached drawings so that a person having ordinary skill in the art to which the present disclosure pertains can easily implement the present disclosure. The present disclosure may be embodied in many different forms and is not limited to the implementations set forth herein.

The drawings and description are to be regarded as illustrative in nature and not restrictive. Like reference numerals designate like elements throughout the specification.

The size and thickness of each constituent element as shown in the drawings are randomly indicated for better understanding and ease of description, and this disclosure is not necessarily limited to as shown. In the drawings, the thickness of layers, regions, etc., are exaggerated for clarity. In addition, in the drawings, for better understanding and ease of description, the thickness of some layers and areas is exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means being disposed on or below the object portion, and does not necessarily mean being disposed on the upper side of the object portion based on a gravitational direction.

As used herein, the phrase "at least one of A, B or C" (or similar phrasing including more listed elements) refers to any one of the listed elements individually, or any combination of two or more of the listed elements, up to and including all listed elements.

In addition, in this specification, the phrase "on a plane" means viewing a target portion from the top, and the phrase "on a cross-section" means viewing a cross-section formed by vertically cutting a target portion from the side.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

The term "overlap" (or "overlapping", or like terms), as may be used herein, is intended to broadly refer to a first element that intersects with at least a portion of a second element when viewed in a particular direction (e.g., in a third direction D3, perpendicular to the upper surface of a substrate). Components or layers described with reference to "overlap" in a particular direction may be at least partially obstructed by one another when viewed along a line extending in the particular direction. For instance, components or layers described with reference to "overlap" in a particular direction may be positioned such that a line that runs parallel to the particular direction may be positioned such that it intersects at least a portion of each of the components or layers.

As used herein, the terms "substantially," "about," and similar terms are used as terms of approximation and not as terms of degree, and are intended to account for the inherent variations in measured or calculated values that would be recognized by those of ordinary skill in the art. Parameters and/or ends of ranges that are quoted as being "about" a certain value (e.g. "about X") may be considered equal to that value (e.g. "equal to X"). Nevertheless, any values quoted herein may include variations of that value within commonly accepted errors, margins and/or tolerances (e.g. manufacturing tolerances). For instance, any values quoted herein may also cover variations within ±5% or ±10%.

Additionally, throughout the specification, the direction vertical (e.g., perpendicular) to the upper surface of the substrate is described as a third direction D3, and the two directions that are parallel to the upper surface of the substrate and intersect each other are described as a first direction D1 and a second direction D2 respectively. For example, the first direction D1 and the second direction D2 may be perpendicular to each other. As an alternative to defining the directions relative to the upper surface of the substrate, the directions may be similarly defined relative to one or more other layers (e.g., an upper surface or lower surface of a channel layer of the semiconductor device). For instance, the third direction may be a thickness direction of the channel layer. The third direction may be a height direction (e.g., a vertical direction). Features or elements that are defined as "above" other features or elements may be located further along the third direction than the other features or elements. Similarly, "upper" features or elements may be considered above corresponding "lower" features or elements. It will be appreciated that the positions and directions defined herein are defined relative to the structure of the semiconductor device and therefore need not limit the semiconductor device to user in any particular orientation.

Certain embodiments relate to materials that have different etch selectivities. This might be understood to refer to materials that have etch selectivity relative to each other (e.g., for a particular etching process (e.g., a particular etchant)). For instance, the materials may have different etch rates. Etch selectivity may be the ratio of the etch rate of a first material to the etch rate of a second material. The etch rates may be based on a particular etching process (e.g., a particular etchant). The first material may be a material that is intended to be etched by the etching process, and the second material may be a material that is intended not to be etched by the etching process. The strength of the etch selectivity may increase as the ratio of etch rates moves further from 1 (e.g., as the ratio increases). For two materials that have etch selectivity relative to each other for a particular etching process, one material may be etched by the etching process, whereas the other material may not be etched (or may be only partially etched). For instance, for two materials to have etch selectivity, the etch selectivity (e.g., the etch selectivity ratio) may be greater than or equal to 5. As another example, for two materials to have etch selectivity, the etch selectivity (e.g., the etch selectivity ratio) may be greater than or equal to 10. For instance, for two materials to have etch selectivity, the etch selectivity (e.g., the etch selectivity ratio) may be greater than or equal to 20.

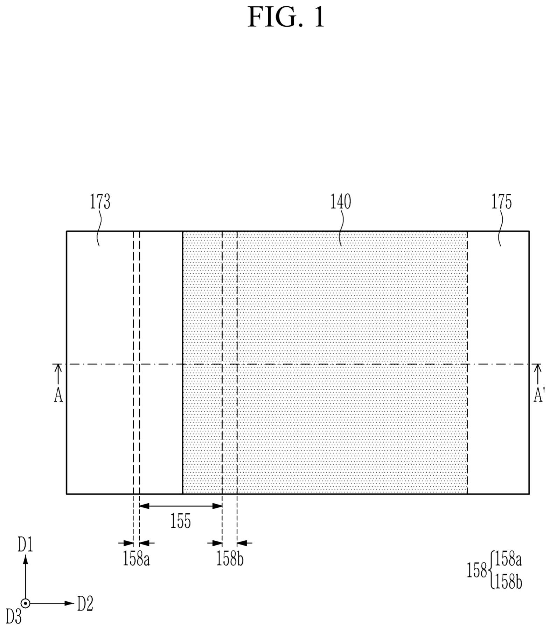

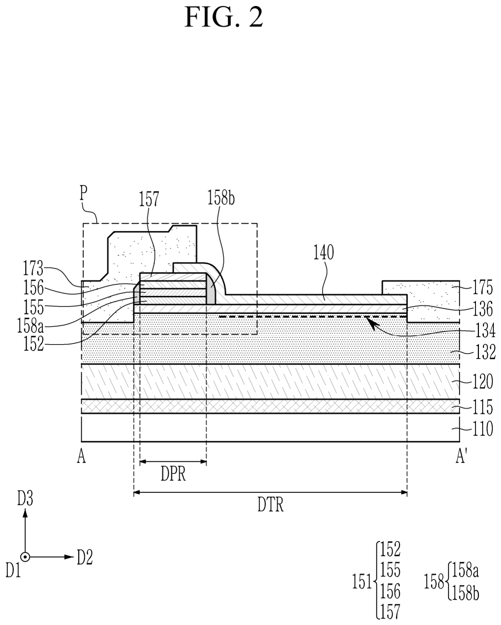

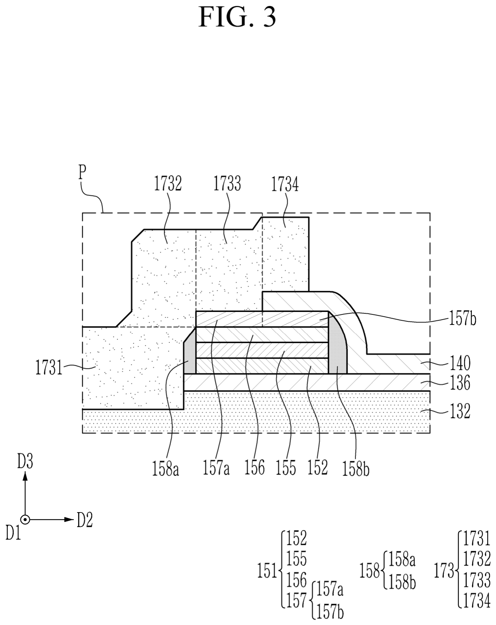

Fig. 1 is a plan view showing a semiconductor device according to some implementations. Fig. 2 is a cross-sectional view taken along the line A-A' of Fig. 1. Fig. 3 is a cross-sectional view enlarging the P portion of Fig. 2.

For clear understanding and simplified illustration, Fig. 1 mainly illustrates a first protective layer 140, a gate electrode layer 155, a gate spacer 158, a source electrode 173, and a drain electrode 175.

Referring to Figs. 1 to 3, a semiconductor device includes a channel layer 132, a barrier layer 136 positioned on the channel layer 132, a gate structure 151 positioned on the barrier layer 136, a gate spacer 158 positioned on a side surface of the gate structure 151, and a source electrode 173 and a drain electrode 175 positioned on both (e.g., opposite) sides of the gate electrode layer 155 and connected (e.g., electrically connected) to the channel layer 132.

The channel layer 132 is a layer that is configured to form a channel between the source electrode 173 and the drain electrode 175, and within the channel layer 132, a two-dimensional electron gas (2DEG) 134 may be located. The two-dimensional electron gas 134 refers to a charge transport model used in solid-state physics, within which electrons may move freely in two dimensions (for example, in the D1-D2 plane direction) but are unable to move in another dimension (for example, in the D3 direction) and are tightly confined within two dimensions. That is, the two-dimensional electron gas 134 may exist in a form similar to a sheet of paper within three-dimensional space. This two-dimensional electron gas 134 is primarily observed in semiconductor heterojunction structures, and in some implementations of a semiconductor device, it may occur at the interface between the channel layer 132 and the barrier layer 136. For example, the two-dimensional electron gas 134 may occur in the portion of the channel layer 132 closest to the barrier layer 136.

The channel layer 132 may include nitrides including Group III-V materials, for example, Al, Ga, In, B, or a combination thereof. The channel layer 132 may be formed as a single layer or a multilayer. For example, the channel layer 132 may include AlₓIn_{y}Ga_{1-x-y}N (0≤x≤1, 0≤y≤1, x+y≤1), and, for example, the channel layer 132 may include AIN, GaN, InN, InGaN, AlGaN, AlInN, AlInGaN, or a combination thereof. The channel layer 132 may be a layer doped with impurities, or it may be an undoped layer. The thickness of the channel layer 132 may be about several hundred nm or less.

The channel layer 132 may be positioned on a substrate 110, and between the substrate 110 and the channel layer 132, a seed layer 115 or a buffer layer 120 may be positioned. The substrate 110, the seed layer 115, or the buffer layer 120 are layers utilized for forming the channel layer 132 and may be omitted in some cases. For example, when using a substrate made of GaN as the channel layer 132, at least one of the substrate 110, the seed layer 115, or the buffer layer 120 may be omitted. Considering that a GaN substrate is relatively expensive, the substrate 110 made of Si may be used to grow the channel layer 132 including GaN. At this time, due to the difference in lattice structures between Si and GaN, it may not be easy to grow the channel layer 132 directly on the substrate 110. Accordingly, the seed layer 115 and the buffer layer 120 may first be grown on the substrate 110, and then the channel layer 132 may be grown on the buffer layer 120. Also, at least one of the substrate 110, the seed layer 115, or the buffer layer 120 may be removed in the final structure of the semiconductor device after being used in the manufacturing process.

The substrate 110 may include a semiconductor material. For example, the substrate 110 may include sapphire, Si, SiC, AIN, GaN, or a combination thereof. The substrate 110 may also be a SOI (Silicon on Insulator) substrate. However, the material of the substrate 110 is not limited thereto and may apply to any substrate commonly used. In some cases, the substrate 110 may include an insulating material. For example, after forming various layers including the channel layer 132 on the semiconductor substrate, the semiconductor substrate may be removed and replaced with an insulating substrate.

The seed layer 115 may be positioned on the substrate 110. The seed layer 115 may be positioned directly on the substrate 110. However, it is not limited thereto, and a certain other layer may be further positioned between the substrate 110 and the seed layer 115. The seed layer 115 is a layer serving as a seed for the growth of the buffer layer 120, and may be composed of a crystal lattice structure that becomes the seed of the buffer layer 120. For example, the seed layer 115 may include AIN, but is not limited thereto.

The buffer layer 120 may be positioned on the seed layer 115. The buffer layer 120 may be positioned directly on the seed layer 115. However, it is not limited thereto, and a predetermined other layer may also be positioned between the seed layer 115 and the buffer layer 120. The buffer layer 120 may be positioned between the seed layer 115 and the channel layer 132. The buffer layer 120 may include a nitride including Group III-V materials, such as Al, Ga, In, B, or a combination thereof. The buffer layer 120 may include AlₓIn_{y}Ga_{1-x-y}N (0≤x≤1, 0≤y≤1, x+y≤1), and for example, the buffer layer 120 may include AIN, GaN, InN, InGaN, AlGaN, AlInN, AlInGaN, or a combination thereof. The buffer layer 120 may be composed of a single layer or multiple layers. For example, the buffer layer 120 may include a superlattice layer and a high resistance layer.

The superlattice layer may alleviate the difference in lattice constant and thermal expansion coefficient between the substrate 110 and the channel layer 132, thereby alleviating the tensile stress and compressive stress generated between the substrate 110 and the channel layer 132. The high-resistance layer may be for preventing a semiconductor device according to some implementations from deteriorating by preventing leakage current from flowing through the channel layer 132. To this end, the high-resistance layer may be made of a material having low conductivity so that the space between the substrate 110 and the channel layer 132 may be electrically insulated. The high resistance layer 126 may be otherwise known as an insulating layer. For instance, the high resistance layer 126 may have a resistivity that is higher than that of silicon.

The barrier layer 136 may be positioned on the channel layer 132. The barrier layer 136 may be positioned directly on the channel layer 132. However, it is not limited thereto, and other layers may be positioned between the channel layer 132 and the barrier layer 136. The region of the channel layer 132 overlapping with the barrier layer 136 may become a drift region DTR. The drift region DTR may be positioned between the source electrode 173 and the drain electrode 175. When a potential difference occurs between the source electrode 173 and the drain electrode 175, carriers may move in the drift region DTR (e.g., when the semiconductor device is turned on). Depending on whether a voltage is applied to the gate electrode layer 155 and the magnitude of the voltage applied to the gate electrode layer 155, the semiconductor device may be turned on/off. When a voltage equal to or greater than the threshold voltage is applied to the gate electrode layer 155 and the semiconductor device is in an on state, a channel may be formed in the depletion region DPR. As a result, movement of carriers in the drift region DTR may occur. If a voltage lower than the threshold voltage is applied to the gate electrode layer 155 or no voltage is applied, the channel path in the depletion region DPR may be blocked, and movement of carriers may not occur.

The barrier layer 136 may include nitrides including Group III-V materials, for example, Al, Ga, In, B, or a combination thereof. The barrier layer 136 may include AlₓIn_{y}Ga_{1-x-y}N (0≤x≤1, 0≤y≤1, x+y≤1), and for example, the barrier layer 136 may include GaN, InN, AlGaN, AlInN, InGaN, AIN, AlInGaN, or a combination thereof. The energy band gap of the barrier layer 136 may be adjusted by the composition ratio of Al or In. The barrier layer 136 may be doped with a predetermined impurity. In this case, the impurity doped into the barrier layer 136 may be a p-type dopant that may provide holes. For example, the impurity doped into the barrier layer 136 may be magnesium (Mg). By increasing or decreasing the impurity doping concentration of the barrier layer 136, the threshold voltage, on-resistance, etc. of the semiconductor device may be controlled.

The barrier layer 136 may include a semiconductor material having different properties from the channel layer 132. The barrier layer 136 may differ from the channel layer 132 in terms of polarizing characteristics, energy band gap, and lattice constant, at least one of which may be different. For example, the barrier layer 136 may include a material having a different energy band gap from the channel layer 132. In this case, the barrier layer 136 may have a higher energy band gap than the channel layer 132. In addition, or alternatively the barrier layer 135 may also have a higher electric polarization rate (e.g., a higher electric polarizability) than the channel layer 132. Due to the barrier layer 136, the two-dimensional electron gas 134 may be induced in the channel layer 132 which has a relatively lower electric polarization rate (e.g., a lower electric polarizability). In this regard, the barrier layer 136 may also be referred to as a channel supply layer or a two-dimensional electron gas supply layer. The two-dimensional electron gas 134 may be formed within a portion of the channel layer 132 positioned below the interface between the channel layer 132 and the barrier layer 136. The two-dimensional electron gas 134 may have very high electron mobility. When considering the relative characteristics (e.g., energy band gaps) of various layers, these characteristics may be considered using fixed measurement conditions, for instance, at the same temperature and pressure (e.g., at room temperature and pressure, such as at 20°C and at 1 atm).

The barrier layer 136 may be formed as a single layer or a multilayer. When the barrier layer 136 is formed of multiple layers, the materials of each layer constituting the multiple layers may have different energy band gaps. In this case, the plurality of layers forming the barrier layer 136 may be arranged such that the energy band gap increases as they are positioned closer to the channel layer 132

The gate structure 151 may be positioned on the barrier layer 136. The gate structure 151 may include a gate semiconductor layer 152, a gate electrode layer 155, and a first hard mask layer 157.

The gate electrode layer 155 may be positioned on the barrier layer 136. The gate electrode layer 155 may overlap with some regions of the barrier layer 136 in the third direction D3. The gate electrode layer 155 may overlap with a portion of the drift region DTR of the channel layer 132 in the third direction D3. The gate electrode layer 155 may be positioned between the source electrode 173 and the drain electrode 175 in the second direction D2. The gate electrode layer 155 may be spaced apart from the source electrode 173 and the drain electrode 175 in the second direction D2. The gate electrode layer 155 may extend along the first direction D1 on a plane. That is, the gate electrode layer 155 may have an elongated (e.g., bar) shape that extends lengthwise along the first direction D1 on a plane.

The gate electrode layer 155 may include a conductive material. For example, the gate electrode layer 155 may include metals, metal alloys, conductive metal nitrides, metal silicides, doped semiconductor materials, conductive metal oxides, or conductive metal oxynitrides. For example, the gate electrode layer 155 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel-platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The gate electrode layer 155 may be composed as a single layer or multiple layers.

The gate semiconductor layer 152 may be positioned between the barrier layer 136 and the gate electrode layer 155. That is, the gate semiconductor layer 152 may be positioned on the barrier layer 136, and the gate electrode layer 155 may be positioned on the gate semiconductor layer 152. The gate electrode layer 155 may be in Schottky contact with the gate semiconductor layer 152. However, it is not limited thereto, and in some cases, the gate electrode layer 155 may also be in ohmic contact with the gate semiconductor layer 152. The gate semiconductor layer 152 may overlap with the gate electrode layer 155 in the third direction D3. The upper surface of the gate semiconductor layer 152 may be entirely covered by the gate electrode layer 155.

The gate semiconductor layer 152 may be positioned between the source electrode 173 and the drain electrode 175 in the second direction D2. The gate semiconductor layer 152 may be spaced apart from the source electrode 173 and the drain electrode 175 in the second direction D2. The gate semiconductor layer 152 may be positioned closer to the source electrode 173 than to the drain electrode 175. That is, the spacing distance between the gate semiconductor layer 152 and the source electrode 173 may be smaller than the spacing distance between the gate semiconductor layer 152 and the drain electrode 175.

The gate semiconductor layer 152 may include a nitride including Group III to V materials, for example, Al, Ga, In, B, or a combination thereof. The gate semiconductor layer 152 may include AlₓIn_{y}Ga_{1-x-y}N (0≤x≤1, 0≤y≤1, x+y≤1). For example, the gate semiconductor layer 152 may include AIN, GaN, InN, InGaN, AlGaN, AlInN, AlinGaN, or a combination thereof. The gate semiconductor layer 152 may include a material having an energy bandgap different from the barrier layer 136. For example, the gate semiconductor layer 152 may include GaN, and the barrier layer 136 may include AlGaN. The gate semiconductor layer 152 may be doped with a predetermined impurity. In this case, the impurity doped in the gate semiconductor layer 152 may be a p-type dopant capable of providing holes. For example, the gate semiconductor layer 152 may include GaN doped with a p-type impurity. That is, the gate semiconductor layer 152 may be formed of a p-GaN layer. However, it is not limited thereto, and the gate semiconductor layer 152 may also be a p-AlGaN layer. The impurity doped in the gate semiconductor layer 152 may be magnesium (Mg). The gate semiconductor layer 152 may be composed of a single layer or multiple layers.

The depletion region DPR may be formed in the channel layer 132 by the gate semiconductor layer 152. The depletion region DPR may be positioned within the drift region DTR and may have a narrower width (e.g., in the second direction D2) than the drift region DTR. As the gate semiconductor layer 152, having a different energy band gap from the barrier layer 136, is positioned on the barrier layer 136, the energy band level (e.g., conduction band level) of the portion of the barrier layer 136 overlapping with the gate semiconductor layer 152 may be elevated. Accordingly, the depletion region DPR may be formed in the region of the channel layer 132 overlapping with the gate semiconductor layer 152. The depletion region DPR may be the area in the channel path of the channel layer 132 where the two-dimensional electron gas 134 is not formed or has a lower electron concentration compared to the remaining areas. In other words, the depletion region DPR may indicate the area within the drift region DTR where the flow of the two-dimensional electron gas 134 is interrupted. As the depletion region DPR occurs, current may not flow between the source electrode 173 and the drain electrode 175, and the channel path may be blocked. Accordingly, the semiconductor device may have a normally off characteristic.

The semiconductor device may be a field effect transistor (FET). The semiconductor device may be a high electron mobility transistor (HEMT). A HEMT may be a FET whose operational channel is formed by a two-dimensional electron gas (2DEG) confined at the interface of a heterojunction formed between two semiconductor materials with different electrical properties (e.g., different bandgaps and/or levels of electrical polarizability). The semiconductor device may be a normally-off semiconductor device HEMT. In the normal state where no voltage is applied to the gate electrode layer 155, the depletion region DPR exists, and the semiconductor device may be in the off state. Although not depicted, when a voltage equal to or greater than the threshold voltage is applied to the gate electrode layer 155, the depletion region DPR disappears, and the two-dimensional electron gas 134 within the drift region DTR may remain uninterrupted and may connect. That is, the two-dimensional electron gas 134 may be formed throughout the entire channel path between the source electrode 173 and the drain electrode 175, and the semiconductor device may be in the on state. In summary, the semiconductor device may include semiconductor layers having different electrical polarization characteristics, and a semiconductor layer with a relatively high polarization rate may induce the two-dimensional electron gas 134 in another heterojunctioned semiconductor layer. This two-dimensional electron gas 134 may be utilized as the channel between the source electrode 173 and the drain electrode 175, and the continuity or interruption of the flow of this two-dimensional electron gas 134 may be controlled by the bias voltage applied to the gate electrode layer 155. In the gate-off state, the flow of the two-dimensional electron gas 134 is blocked, and no current may flow between the source electrode 173 and the drain electrode 175. As the flow of the two-dimensional electron gas 134 continues in the gate-on state, current may flow between the source electrode 173 and the drain electrode 175.

The semiconductor device has been described in the case of a normally-off high electron mobility transistor; however, it is not limited thereto. For example, the semiconductor device may be a normally-on high electron mobility transistor. In the case of a normally-on high electron mobility transistor, the gate semiconductor layer 152 may be omitted, and accordingly, the gate electrode layer 155 may be positioned directly on the barrier layer 136. That is, the gate electrode layer 155 may contact with the barrier layer 136. However, it is not limited to thereto, and a gate dielectric layer may be interposed between the gate electrode layer 155 and the barrier layer 136. In such a structure, the two-dimensional electron gas 134 may be used as a channel in a state where no voltage is applied to the gate electrode layer 155, and a flow of current may occur between the source electrode 173 and the drain electrode 175. Additionally, when a negative voltage is applied to the gate electrode layer 155, the depletion region DPR may be generated, where the flow of the two-dimensional electron gas 134 is interrupted below the gate electrode layer 155.

The previously described the buffer layer 120, the channel layer 132, the barrier layer 136, and the gate semiconductor layer 152 may be sequentially stacked on a substrate 110. In the semiconductor device, at least one of the buffer layer 120, the barrier layer 136, and the gate semiconductor layer 152 may be omitted. The buffer layer 120, the channel layer 132, the barrier layer 136, and the gate semiconductor layer 152 may be formed of semiconductor material with the same base, and the material composition ratio of each layer may differ considering the role of each layer, the performance required of the semiconductor device, etc.

The first hard mask layer 157 may be positioned on the gate electrode layer 155.

The first hard mask layer 157 may overlap with the gate electrode layer 155 in the third direction D3. The upper surface of the gate electrode layer 155 may be entirely covered by the first hard mask layer 157. The first hard mask layer 157 may extend in the first direction D1 along the gate electrode layer 155. That is, the first hard mask layer 157 may have a bar shape extending lengthwise in the first direction D1 on a plane.

For example, the semiconductor device may form the gate electrode layer 155 first and then form the gate semiconductor layer 152 using the gate electrode layer 155, after which a source electrode 173 may be formed. In this case, the gate semiconductor layer 152 and the gate electrode layer 155 may be self-aligned, and the alignment between the gate electrode layer 155 and the gate semiconductor layer 152 is easy and excellent.

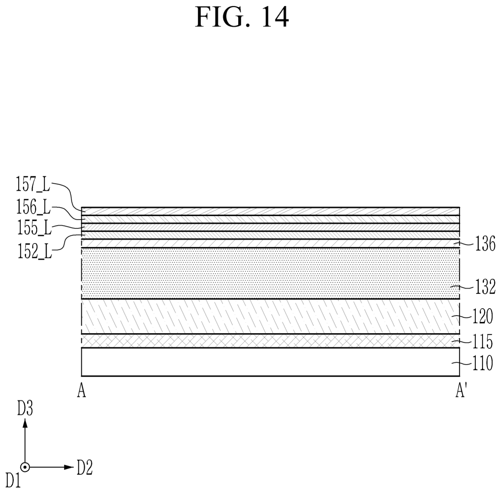

For example, as described later with reference to Figs. 14 to 17, the gate electrode layer 155 may be formed by etching with a first etching gas using a first photoresist pattern 291, removing the first photoresist pattern 291, and etching with a second etching gas, which is different from the first etching gas, using the first hard mask layer 157 to form the gate semiconductor layer 152. That is, as the gate electrode layer 155 may be formed using the first photoresist pattern 291 and the gate semiconductor layer 152 may be formed using the first hard mask layer 157, the gate electrode layer 155 may be etched with the first etching gas, and the gate semiconductor layer 152 may be etched with the second etching gas, increasing the degree of freedom in selecting the etching material for the gate electrode layer 155 and the gate semiconductor layer 152.

Additionally, when the gate electrode layer 155 is etched with the first etching gas, generated by-products may affect the gate semiconductor layer 152 during etching with the second etching gas, potentially causing defects. To solve this problem, after etching the gate electrode layer 155 with the first etching gas, processes such as ashing or stripping may be employed to remove by-products generated during the etching of the gate electrode layer 155 with the first etching gas before etching the gate semiconductor layer 152 with the second etching gas. Accordingly, the defect problem due to by-products that arise when etching different materials of the gate electrode layer 155 and the gate semiconductor layer 152 with different etching materials may be resolved.

The by-product removal process through steps such as ashing or stripping may also remove the first photoresist pattern 291. In this process, the first hard mask layer 157 may not be removed. Subsequently, the first hard mask layer 157 may be used as a mask in the process of forming the gate semiconductor layer 152 using the second etching gas.

The first hard mask layer 157, depending on the etching conditions during the etching of the gate semiconductor layer 152, may have a shape in which the edge formed by the upper surface and side surfaces of the first hard mask layer 157 is rounded.

If the first hard mask layer 157 includes the same material as the first protective layer 140 described later, the boundary between the first hard mask layer 157 and the first protective layer 140 may not be distinguished (e.g., the first hard mask layer 157 may be integrated with the first protective layer 140).

In some implementations, the gate structure 151 may further include a second hard mask layer 156 between the gate electrode layer 155 and the first hard mask layer 157.

The second hard mask layer 156 may overlap with the gate electrode layer 155 in the third direction D3. The upper surface of the gate electrode layer 155 may be entirely covered by the second hard mask layer 156. The second hard mask layer 156 may extend in the first direction D1 along the gate electrode layer 155. That is, the second hard mask layer 156 may have a bar shape extending longitudinally in the first direction D1 on a plane.

If the second hard mask layer 156 includes the same material as the gate spacer 158 described later, the boundary of the second hard mask layer 156 and the gate spacer 158 may not be distinguishable (e.g., the second hard mask layer 156 may be integrated with the gate spacer 158).

For example, the first hard mask layer 157 and the second hard mask layer 156 may each independently include an insulating material, a metal material, a metal nitride, a metal carbide, a dielectric material, a semiconductor material, or a combination thereof.

The insulating material may include, for example, silicon oxide, silicon oxynitride, silicon oxycarbide, silicon nitride, or a combination thereof. The metal material may include titanium (Ti), titanium aluminum (TiAl), tantalum (Ta), tungsten (W), aluminum (Al), copper (Cu), cobalt (Co), nickel (Ni), platinum (Pt), nickel platinum (Ni-Pt), niobium (Nb), molybdenum (Mo), ruthenium (Ru), rhodium (Rh), palladium (Pd), iridium (Ir), osmium (Os), silver (Ag), gold (Au), zinc (Zn), vanadium (V), or a combination thereof. the metal nitride may include titanium nitride (TiN), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), molybdenum nitride (MoN), niobium nitride (NbN), titanium aluminum carbonitride (TiAIC-N), tantalum carbonitride (TaCN), or a combination thereof. The metal carbide may include titanium carbide (TiC), tantalum carbide (TaC), tungsten carbide (WC), niobium carbide (NbC), molybdenum carbide (MoC), titanium aluminum carbide (TiAIC), or a combination thereof. The dielectric material may include hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, lead zinc niobate, or a combination thereof. The semiconductor material may include Si, AIN, GaN, InN, InGaN, AlGaN, AlInN, AlinGaN, or a combination thereof.

The gate spacer 158 may be positioned on a side surface of the gate structure 151. For example, the gate spacer 158 may cover the side surface of the gate semiconductor layer 152 and the gate electrode layer 155. The gate spacer 158 may protect the gate electrode layer 155 during the etching of the first protective layer 140 for the formation of the source electrode 173, preventing damage to the gate electrode layer 155. Additionally, the gate spacer 158, depending on the implementation, may or may not cover the side surface of the first hard mask layer 157 and the second hard mask layer 156. The gate spacer 158 may extend in the third direction D3 along both side surfaces of the gate structure 151.

The gate spacers 158 may be positioned on both side surfaces in the second direction D2 of the gate structure 151. The gate spacer 158 may include a first gate spacer 158a positioned on one side surface in the second direction D2 of the gate structure 151 and a second gate spacer 158b positioned on the other side surface in the second direction D2 of the gate structure 151. The first gate spacer 158a may be positioned on the side surface facing the source electrode 173 of the gate structure 151, and the second gate spacer 158b may be positioned on the side surface facing the drain electrode 175 of the gate structure 151. In other words, the first gate spacer 158a may be positioned between the gate structure 151 and the source electrode 173, and the second gate spacer 158b may be positioned between the gate structure 151 and the drain electrode 175.

The first gate spacer 158a may contact with the source electrode 173. For example, one side surface in the second direction D2 of the first gate spacer 158a may directly contact with the source electrode 173, and the other side surface in the second direction D2 of the first gate spacer 158a may directly contact with the gate structure 151. Meanwhile, one side surface in the second direction D2 of the second gate spacer 158b may directly contact with the gate structure 151, and the other side surface in the second direction D2 of the second gate spacer 158b may directly contact with the first protective layer 140.

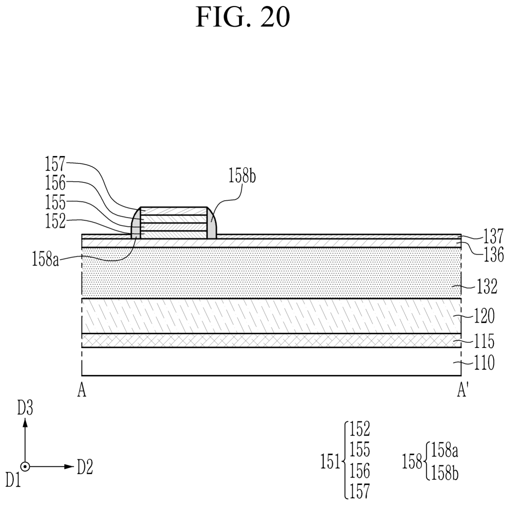

As described later with reference to Figs. 20 to 23, to form the source electrode 173, the first protective layer 140 may be formed, the first protective layer 140 positioned on the first gate spacer 158a may be removed using the second photoresist pattern 292 as an etch mask to expose the first gate spacer 158a, and the source electrode 173 may be formed to contact with the first gate spacer 158a at the removed position of the first protective layer 140. When removing the first protective layer 140 to expose the first gate spacer 158a, a portion of the first gate spacer 158a may be etched. For example, in a cross-section cut (for example, Fig. 3) in the second direction D2 and the third direction D3 perpendicularly to the first direction D1 which is an extending direction of the gate structure 151, the first gate spacer 158a and the second gate spacer 158b may have different cross-sectional shapes from each other. In other words, the first gate spacer 158a and the second gate spacer 158b may have an asymmetrical mirror-image shape.

For example, the upper level of the first gate spacer 158a may be lower than the upper level of the second gate spacer 158b. Also, the width of the first gate spacer 158a may be smaller than the width of the second gate spacer 158b. In other words, the size of the first gate spacer 158a may be smaller compared to the size of the second gate spacer 158b.

Here, the upper level of the first gate spacer 158a may be, for example, the distance (e.g., the shortest distance) in the third direction D3 from the upper surface of the substrate 110 to the topmost part of the first gate spacer 158a. Similarly, the upper level of the second gate spacer 158b may be, for example, the distance (e.g., the shortest distance) in the third direction D3 from the upper surface of the substrate 110 to the topmost part of the second gate spacer 158b. Also, the width of the first gate spacer 158a may be the length (e.g., the shortest length) in the second direction D2 from the lowermost part of the first gate spacer 158a, and the width of the second gate spacer 158b may be the length (e.g., the shortest length) in the second direction D2 from the lowermost part of the second gate spacer 158b.

Also, the upper level of the first gate spacer 158a may be lower than the upper level of the gate structure 151, and, for example, the upper level of the first gate spacer 158a may be lower than the upper level of the first hard mask layer 157 of the gate structure 151. Accordingly, at least a portion of the side surfaces in the second direction D2 of the first hard mask layer 157 may not be covered by the first gate spacer 158a. Some or all of the side surface in the second direction D2 of the first hard mask layer 157 not covered by the first gate spacer 158a may contact with the source electrode 173, and, for example, may contact with a first portion 1731 of the source electrode 173 to be described later.

The upper width of the first gate spacer 158a is smaller than the lower width, and the upper width of the second gate spacer 158b may be smaller than the lower width. Here, the width of the first gate spacer 158a may be the length (e.g., the shortest length) in the second direction D2 at the top or bottom, and the width of the second gate spacer 158b may be the length (e.g., the shortest length) in the second direction D2 at the top or bottom.

For example, the length of the first gate spacer 158a in the second direction D2 may decrease as it moves away from the upper surface of the substrate 110. In other words, the side surface in the second direction D2 of the first gate spacer 158a may have a slope. The rate of change of the width of the first gate spacer 158a may increase as it moves away from the upper surface of the substrate 110. The sloped side surface of the first gate spacer 158a may have a convex shape toward the source electrode 173. Similarly, the length of the second gate spacer 158b in the second direction D2 may decrease as it moves away from the upper surface of the substrate 110. In other words, the side surface in the second direction D2 of the second gate spacer 158b may have a slope. The rate of change of the width of the second gate spacer 158b may increase as it moves away from the upper surface of the substrate 110. The sloped side surface of the second gate spacer 158b may have a convex shape toward the first protective layer 140.

For example, the gate spacer 158 may include an insulating material including silicon oxide, silicon oxynitride, silicon carbon oxynitride, silicon nitride, or a combination thereof.

The semiconductor device may further include a first protective layer 140 positioned on the barrier layer 136. The barrier layer 136 or the gate electrode layer 155, among others, may be protected by the first protective layer 140 and may be separated from other components.

The first protective layer 140 may include an insulating material. For example, the first protective layer 140 may include silicon oxide, silicon oxynitride, silicon oxycarbonitride, silicon nitride, or a combination thereof. Additionally, the first protective layer 140 may be composed of a single layer or multiple layers made of an insulating material.

For example, the barrier layer 136 may have a region positioned between the gate structure 151 and the source electrode 173, and a region positioned between the gate structure 151 and the drain electrode 175. The first protective layer 140 is positioned on the region of the barrier layer 136 positioned between the gate structure 151 and the drain electrode 175, but the first protective layer 140 may not be positioned on the region of the barrier layer 136 positioned between the gate structure 151 and the source electrode 173.

As described later with reference to Figs. 20 to 23, when a portion of the first protective layer 140 is removed to form the source electrode 173, the second photoresist pattern 292 is formed to cover at least a portion of the upper surface of the gate structure 151, so a portion of the first protective layer 140 covering the upper surface of the gate structure 151 may be removed, a portion of the first protective layer 140 covering the first gate spacer 158a may be removed, and the first protective layer 140 covering the regions where the source electrode 173 and the drain electrode 175 are to be formed may be removed. In this case, the first protective layer 140 positioned between the gate structure 151 and the source electrode 173 may be removed. Accordingly, the first protective layer 140 may be positioned on the region of the barrier layer 136 positioned between the gate structure 151 and the drain electrode 175, but the first protective layer 140 may not be positioned on the region of the barrier layer 136 positioned between the gate structure 151 and the source electrode 173.

Additionally, the first protective layer 140 may be positioned on at least a portion of the upper surface of the gate structure 151. The first protective layer 140 may cover only a part of the upper surface of the gate structure 151. The first protective layer 140 may overlap only partially with the gate structure 151 in the third direction D3. In other words, one end of the second direction D2 of the first protective layer 140 may be positioned on the upper surface of the gate structure 151.

The first hard mask layer 157 of the gate structure 151 may have a portion 157b covered by the first protective layer 140 and a portion 157a not covered by the first protective layer 140. The side surface in the second direction D2 of the portion 157b of the first hard mask layer 157 covered by the first protective layer 140 may contact with the second gate spacer 158b, and the side surface in the second direction D2 of the portion 157a of the first hard mask layer 157 not covered by the first protective layer 140 may contact with the first gate spacer 158a.

The upper surface of the portion 157a of the first hard mask layer 157 not covered by the first protective layer 140 may contact with the source electrode 173. For example, the upper surface of the portion 157a of the first hard mask layer 157 not covered by the first protective layer 140 may contact with the lower surface of a third portion 1733 of the source electrode 173 described later. In other words, the source electrode 173 may penetrate the first protective layer 140 and contact with the portion 157a of the first hard mask layer 157 not covered by the first protective layer 140.

In addition, the first gate spacer 158a has an asymmetric shape with the second gate spacer 158b and the upper level of the first gate spacer 158a may be lower than the upper level of the first hard mask layer 157, allowing the side surface in the second direction D2 of the first hard mask layer 157 to be exposed and contact with the source electrode 173 without being covered by the first gate spacer 158a. For example, the side surface of the portion 157a of the first hard mask layer 157 not covered by the first protective layer 140 may contact with the side surface of the second portion 1732 of the source electrode 173 described later. In other words, the source electrode 173 may penetrate the first protective layer 140 and contact with the portion 157a of the first hard mask layer 157 not covered by the first protective layer 140.

For example, the first protective layer 140 may extend in the second direction D2 from at least a portion of the upper surface of the gate structure 151 to contact with the drain electrode 175. In other words, one end of the first protective layer 140 in the second direction D2 is positioned on the upper surface of the gate structure 151, and the other end of the first protective layer 140 in the second direction D2 may contact with the drain electrode 175. Accordingly, the first protective layer 140 is positioned on the second gate spacer 158b and may cover the second gate spacer 158b. However, the first protective layer 140 may not extend from at least a portion of the upper surface of the gate structure 151 toward the source electrode 173, so the first protective layer 140 may not be positioned on the first gate spacer 158a and may not cover the first gate spacer 158a. In other words, the first protective layer 140 may not overlap with the first gate spacer 158a in the third direction D3, and may overlap with the second gate spacer 158b.

For example, in the cross-section cut in the second direction D2 and the third direction D3 perpendicularly to the first direction D1 (for example, Fig. 3), the upper level of the first hard mask layer 157 of the gate structure 151 is higher than the upper level of the first gate spacer 158a, the upper level of the first hard mask layer 157 is higher than or equal to the upper level of the second gate spacer 158b, and the upper level of the first hard mask layer 157 may be lower than the upper level of the first protective layer 140 positioned on at least a part of the upper surface of the gate structure 151. Accordingly, the semiconductor device may have a step between the first gate spacer 158a and the first hard mask layer 157 of the gate structure 151, and may have a step between the first hard mask layer 157 of the gate structure 151 and the first protective layer 140.

Here, the upper level of the first hard mask layer 157 may be, for example, the distance (e.g., the shortest distance) from the upper surface of the substrate 110 to the topmost part of the first hard mask layer 157 in the third direction D3. The upper level of the first protective layer 140 may be, for example, the distance (e.g., the shortest distance) from the upper surface of the substrate 110 to the topmost part of the first protective layer 140 in the third direction D3.

In order to reduce the on-resistance of the semiconductor device, it is advantageous to reduce the gap between the gate electrode layer 155 and the source electrode 173. Reducing the gap between the gate electrode layer 155 and the source electrode 173 may shorten the channel length and achieve the effect of lowering some element resistance. However, as it is difficult to reduce the gap between the gate electrode layer 155 and the source electrode 173 while securing the spacing distance between the gate electrode layer 155 and the source electrode 173, the dispersion (e.g., electric field dispersion) of the device may deteriorate.

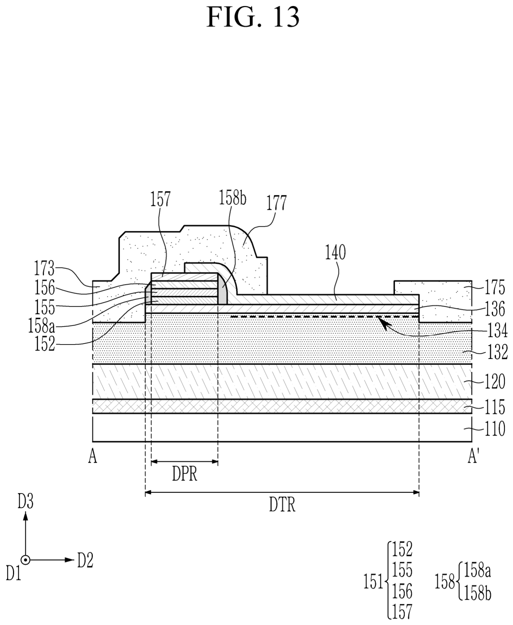

The semiconductor device according to some implementations may be manufactured, as described later in Figs. 13 to 23, by forming the gate structure 151 including the gate semiconductor layer 152, the gate electrode layer 155, and the first hard mask layer 157, forming the gate spacer 158 on the side surface of the gate structure 151, and forming the source electrode 173 in contact with the gate spacer 158. In other words, by using the gate spacer 158, the source electrode 173 may be formed to self-align with the gate structure 151, while minimizing the gap between the gate electrode layer 155 and the source electrode 173.

Accordingly, the semiconductor device includes the gate spacer 158 positioned on the side surface of the gate structure 151, and the source electrode 173 may contact with the gate spacer 158. Additionally, the first hard mask layer 157 of the gate structure 151 of the semiconductor device and the gate spacer 158 may include materials with different etch selectivities.

Through this, the gap between the gate electrode layer 155 and the source electrode 173 may be adjusted through the gate spacer 158, enabling easy control of capacitance and allowing for the minimization of the gap between the gate electrode layer 155 and the source electrode 173, while also solving the misalignment problem of the source electrode 173 resulting from this.

The first hard mask layer 157 of the gate structure 151 and the gate spacer 158 may include materials having different etch selectivities. Through this, the formation process of the gate spacer 158 on the side surface of the gate structure 151 and the contact region etching process for the formation of the source electrode 173 may ensure that the gate electrode layer 155 may not be exposed and damaged.

Here, the etch selectivity between the material included in the first hard mask layer 157 and the material included in the gate spacer 158 may be the etch selectivity when using an etching gas including SF₆. For example, the etching gas including SF₆ may have higher etch selectivity for the material included in the gate spacer 158 than for the material included in the first hard mask layer 157. For example, the etching gas including SF₆ may have higher etch rate for the material included in the gate spacer 158 than for the material included in the first hard mask layer 157.

For example, the gate spacer 158 may include silicon oxide. When the gate spacer 158 includes a low-K material such as silicon oxide, the capacitance may be minimized. A low-K material may be a material having a dielectric constant (K) that is less than or equal to that of silicon oxide. The first hard mask layer 157 may include material with etch selectivity to the silicon oxide of the gate spacer 158, such as silicon nitride or metal material. In this case, the gate spacer 158 may be formed in a manner that prevents damage to the gate electrode layer 155 positioned below the first hard mask layer 157.

Additionally, the second hard mask layer 156 may include a material having etch selectivity relative to the first protective layer 140. The second hard mask layer 156 may include a material having etch selectivity relative to the first hard mask layer 157. Through this, by forming the first protective layer 140, removing the first protective layer 140 positioned on the first gate spacer 158a using the second photoresist pattern 292 as an etching mask to expose the first gate spacer 158a, and forming the source electrode 173 in contact with the first gate spacer 158a at the location where the first protective layer 140 is removed, the second hard mask layer 156 may not be etched during the etching of the first protective layer 140, thereby preventing the gate electrode layer 155 from being exposed and damaged.

Here, the etch selectivity between the material included in the second hard mask layer 156 and the material included in the first protective layer 140 or the first hard mask layer 157 may be the etch selectivity when an etching gas including CF₄ or Cl is used. For example, the etching gas including CF₄ or Cl may have higher etch selectivity for the material included in the first protective layer 140 or the first hard mask layer 157 than for the material included in the second hard mask layer 156. For example, the etching gas including CF₄ or Cl may have higher etch rate for the material included in the first protective layer 140 or the first hard mask layer 157 than for the material included in the second hard mask layer 156.

For example, the first protective layer 140 may include silicon nitride. When the first protective layer 140 includes silicon nitride, it may enhance the channel due to the increase of carriers. The gate spacer 158 may include a low-K material such as silicon oxide. The first hard mask layer 157 may include silicon nitride. In this case, during the etching of the first protective layer 140, the first hard mask layer 157 may also be etched, possibly damaging the gate electrode layer 155 positioned under the first hard mask layer 157. However, as the second hard mask layer 156 includes a material with etch selectivity relative to the first protective layer 140 and the first hard mask layer 157, it may prevent the gate electrode layer 155 positioned under the second hard mask layer 156 from being damaged during the etching of the first protective layer 140. For example, the second hard mask layer 156 may include silicon oxide.

The semiconductor device may further include a second protective layer and a third protective layer positioned on the first protective layer 140. For example, the semiconductor device may include the second protective layer positioned on the first protective layer 140, and the third protective layer positioned on the second protective layer.

The barrier layer 136 or the gate electrode layer 155 may be protected by the second protective layer and the third protective layer, and may be separated from other components. The second protective layer and the third protective layer may include an insulating material. For example, the second protective layer and the third protective layer may include oxides such as SiO₂ or Al₂O₃. In another example, the second protective layer and the third protective layer may include nitrides such as SiN or oxynitrides such as SiON. The first protective layer 140, the second protective layer, and the third protective layer may include the same material, or may include different materials. If the first protective layer 140, the second protective layer, and the third protective layer are made of the same material, the boundary between the first protective layer 140, the second protective layer, and the third protective layer may not be visually distinguishable. The first protective layer 140, the second protective layer, and the third protective layer may each be composed of a single layer or a multilayer.

The source electrode 173 and the drain electrode 175 may be positioned on the channel layer 132. The source electrode 173 and the drain electrode 175 may be spaced apart in the second direction D2, and the gate electrode layer 155 and the gate semiconductor layer 152 may be positioned between the source electrode 173 and the drain electrode 175. The gate electrode layer 155 and the gate semiconductor layer 152 may be spaced apart from the source electrode 173 and the drain electrode 175 in the second direction D2.

The source electrode 173 and the drain electrode 175 may be positioned outside the drift region DTR of the channel layer 132. The interface between the source electrode 173 and the channel layer 132 may be one edge of the drift region DTR. Similarly, the interface between the drain electrode 175 and the channel layer 132 may be the other edge of the drift region DTR. The source electrode 173 may be electrically connected to the channel layer 132 from one side of the gate electrode layer 155. The drain electrode 175 may be electrically connected to the channel layer 132 from the other side of the gate electrode layer 155. For example, a portion of the upper surface of the channel layer 132 may be recessed, and the source electrode 173 and the drain electrode 175 may be connected to the recessed channel layer 132 through the barrier layer 136.

The source electrode 173 and the drain electrode 175 may extend along the first direction D1 on a plane. That is, the source electrode 173 and the drain electrode 175 may each have a bar shape that extends long along the first direction D1 on a plane. The source electrode 173 and the drain electrode 175 may extend in a direction parallel to each other. The source electrode 173 and the drain electrode 175 may extend in a direction parallel to the gate electrode layer 155.

The source electrode 173 and the drain electrode 175 may include a conductive material. For example, the source electrode 173 and the drain electrode 175 may include one or more of metal, metal alloys, conductive metal nitrides, metal silicides, doped semiconductor materials, conductive metal oxides, or conductive metal oxynitrides. For example, the source electrode 173 and the drain electrode 175 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but are not limited thereto. The source electrode 173 and the drain electrode 175 may be composed of a single layer or multi-layer.

The source electrode 173 may contact with the gate spacer 158. Using the gate spacer 158, the source electrode 173 may be formed to self-align with the gate structure 151. The gap between the gate electrode layer 155 and the source electrode 173 may be minimized. Between the source electrode 173 and the gate structure 151, only the gate spacer 158 may be interposed.

For example, the first gate spacer 158a is positioned between the gate structure 151 and the source electrode 173, and the first gate spacer 158a may contact with the source electrode 173. Additionally, a portion or all of the side surface in the second direction D2 of the first hard mask layer 157 not covered by the first gate spacer 158a may contact with the source electrode 173. The first protective layer 140 may not be positioned on a region between the gate structure 151 and the source electrode 173. The upper surface of the portion 157a of the first hard mask layer 157 not covered by the first protective layer 140 may contact with the source electrode 173. The side surface in the second direction D2 of the first hard mask layer 157 may not be covered by the first gate spacer 158a and may contact with the source electrode 173.

For example, the source electrode 173 may have a first portion 1731, a second portion 1732, a third portion 1733, and a fourth portion 1734.

The first portion 1731 of the source electrode 173 may be positioned on the channel layer 132 and may be connected (e.g., electrically connected) to the channel layer 132. The first portion 1731 of the source electrode 173 may be positioned on one side of the gate structure 151 in the second direction D2 and may contact with the side surface of the first gate spacer 158a in the second direction D2. In other words, the first portion 1731 of the source electrode 173 may be positioned opposite to the gate structure 151 in the second direction D2 with the first gate spacer 158a interposed therebetween.

The second portion 1732, the third portion 1733, and the fourth portion 1734 of the source electrode 173 may be positioned at a higher level than the upper level of the first portion 1731 of the source electrode 173, and may extend from the first portion 1731 of the source electrode 173 in the second direction D2 over the gate structure 151 and may be positioned sequentially. In other words, the second portion 1732 may be positioned on the first portion 1731 of the source electrode 173, the third portion 1733 may be positioned next to the second portion 1732 in the second direction D2, and the fourth portion 1734 may be positioned next to the third portion 1733 in the second direction D2.

The second portion 1732 of the source electrode 173 may be positioned on the first portion 1731 of the source electrode 173 and the first gate spacer 158a. The third portion 1733 of the source electrode 173 may be positioned on the gate structure 151. The third portion 1733 of the source electrode 173 may be positioned on the gate structure 151 not covered by the first protection layer 140. The fourth portion 1734 of the source electrode 173 may be positioned on the first protection layer 140. The fourth portion 1734 of the source electrode 173 may be positioned on the first protection layer 140 positioned on the gate structure 151.

The second portion 1732 of the source electrode 173 may contact with the side surface of the first hard mask layer 157. The side surface of the portion 157a of the first hard mask layer 157 not covered by the first protective layer 140 may contact with the side surface of the second portion 1732 of the source electrode 173. The third portion 1733 of the source electrode 173 may contact with the upper surface of the first hard mask layer 157. The upper surface of the portion 157a of the first hard mask layer 157 not covered by the first protective layer 140 may contact with the lower surface of the third portion 1733 of the source electrode 173. The fourth portion 1734 of the source electrode 173 may contact with the upper surface of the first protective layer 140.

The upper level of the second portion 1732 or the third portion 1733 of the source electrode 173 is higher than the upper level of the first portion 1731 of the source electrode 173, and may be lower than the upper level of the fourth portion 1734 of the source electrode 173. Accordingly, the source electrode 173 may have a step between the first portion 1731 and the second portion 1732, and may have a step between the third portion 1733 and the fourth portion 1734.

Here, the upper levels of the first portion 1731, second portion 1732, third portion 1733, and fourth portion 1734 of the source electrode 173 may be, for example, the distance (e.g., the shortest distance) in the third direction D3 from the upper surface of the substrate 110 to the topmost part of each of the first portion 1731, second portion 1732, third portion 1733, and fourth portion 1734 of the source electrode 173.

In some implementations, the source electrode 173 may include a lower source electrode, an intermediate source electrode, and an upper source electrode. For example, the source electrode 173 shown in Figs. 1 to 3 may show only the lower source electrode.

The intermediate source electrode may be positioned on the lower source electrode. The upper source electrode may be positioned on the intermediate source electrode. The lower source electrode may directly contact with the channel layer 132 and may be electrically connected to the channel layer 132. The intermediate source electrode and the upper source electrode may not directly contact with the channel layer 132 and may be electrically connected to the channel layer 132 through the lower source electrode.

The drain electrode 175 may include a lower drain electrode, an intermediate drain electrode, and an upper drain electrode. For example, the drain electrode 175 shown in Figs. 1 to 3 may show only the lower drain electrode.

The intermediate drain electrode may be positioned on the lower drain electrode. The upper drain electrode may be positioned on the intermediate drain electrode. The lower drain electrode may directly contact with the channel layer 132 and may be electrically connected to the channel layer 132. The intermediate drain electrode and the upper drain electrode may not directly contact with the channel layer 132 and may be electrically connected to the channel layer 132 through the lower drain electrode.

The upper surfaces of the lower source electrode and the lower drain electrode may be positioned on the first protective layer 140. The upper surfaces of the lower source electrode and the lower drain electrode may be positioned between the first protective layer 140 and the second protective layer. Trenches that penetrate the first protective layer 140 and the barrier layer 136, and recess the upper surface of the channel layer 132, may be positioned spaced apart on both sides of the gate electrode layer 155. The lower source electrode and the lower drain electrode may be positioned in the trenches located on both sides of the gate electrode layer 155. The lower source electrode and the lower drain electrode may be formed to fill the trench. Within the trench, the lower source electrode may contact with the channel layer 132. Also, within the trench, the lower drain electrode may contact with the channel layer 132. The channel layer 132 may form the bottom surface and side surfaces of the trench. Accordingly, the lower source electrode and the lower drain electrode may contact with the bottom surface and the side surfaces of the channel layer 132.

The upper surface of the lower source electrode and the lower drain electrode may protrude beyond the upper surface of the first protective layer 140. Additionally, a portion of the lower source electrode and the lower drain electrode may cover at least a portion of the upper surface of the first protective layer 140. A second protective layer may be positioned on the lower source electrode and the lower drain electrode. At least a portion of the lower source electrode and the lower drain electrode may be covered by the second protective layer.

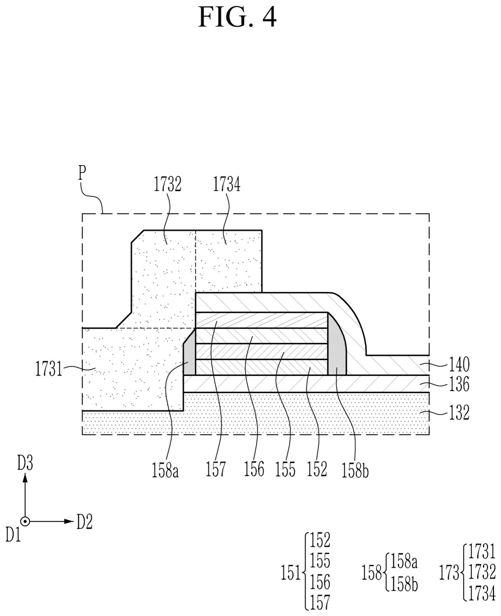

Fig. 4 is a cross-sectional view enlarging the P portion of Fig. 2, illustrating another implementation.

The implementation shown in Fig. 4 is similar to the implementation shown in Fig. 3, so the explanation for these parts will be omitted and the differences will be primarily explained. Additionally, the same reference numerals are used for components that are the same as in the preceding implementation.

Fig. 3 illustrates a case where the first protective layer 140 is positioned on a portion of the upper surface of the gate structure 151.

Referring to Fig. 4, the first protective layer 140 may cover the entire upper surface of the gate structure 151. The first protective layer 140 may completely overlap with the gate structure 151 in the third direction D3.

The first hard mask layer 157 of the gate structure 151 may have only the portion covered by the first protective layer 140, and may not have a portion not covered by the first protective layer 140. The upper surface of the first hard mask layer 157 may not contact with the source electrode 173.

Since the first gate spacer 158a has an asymmetric shape with the second gate spacer 158b, and the upper level of the first gate spacer 158a may be lower than the upper level of the first hard mask layer 157, the side surface in the second direction D2 of the first hard mask layer 157 may not be covered by the first gate spacer 158a and may contact with the source electrode 173. For example, the side surface of the first hard mask layer 157 may contact with the side surface of the second portion 1732 of the source electrode 173.

For example, the first protective layer 140 may extend in the second direction D2 from one end of the upper surface of the gate structure 151 to the point where it contacts with the drain electrode 175. In other words, one end in the second direction D2 of the first protective layer 140 may be positioned on one end of the upper surface of the gate structure 151 in the second direction D2, and the other end in the second direction D2 of the first protective layer 140 may contact with the drain electrode 175. Accordingly, the first protective layer 140 is positioned on the second gate spacer 158b and may cover the second gate spacer 158b. However, since the first protective layer 140 does not extend from one end of the upper surface of the gate structure 151 in the second direction D2 toward the source electrode 173, the first protective layer 140 may not be positioned on the first gate spacer 158a and may not cover the first gate spacer 158a. In other words, the first protective layer 140 does not overlap with the first gate spacer 158a in the third direction D3, and may overlap with the second gate spacer 158b in the third direction D3.

The source electrode 173 may have the first portion 1731, the second portion 1732, and the fourth portion 1734, and may not have the third portion 1733.

The first portion 1731 of the source electrode 173 may be positioned on one side of the gate structure 151 in the second direction D2, and may contact with the side surface in the second direction D2 of the first gate spacer 158a. The second portion 1732 of the source electrode 173 may be positioned on the first portion 1731 of the source electrode 173 and the first gate spacer 158a. The fourth portion 1734 of the source electrode 173 may be positioned on the first protective layer 140. The fourth portion 1734 of the source electrode 173 may be positioned on the first protective layer 140 that is positioned on the gate structure 151.

As the first protective layer 140 covers the entire upper surface of the gate structure 151, the source electrode 173 may not have a third portion 1733 of the source electrode 173 that contacts with the upper surface of the gate structure 151.

The upper level of the second portion 1732 of the source electrode 173 may be higher than the upper level of the first portion 1731 of the source electrode 173 and may be equal to the upper level of the fourth portion 1734 of the source electrode 173. Accordingly, the source electrode 173 may have a step between the first portion 1731 and the second portion 1732, and may not have a step between the second portion 1732 and the fourth portion 1734.

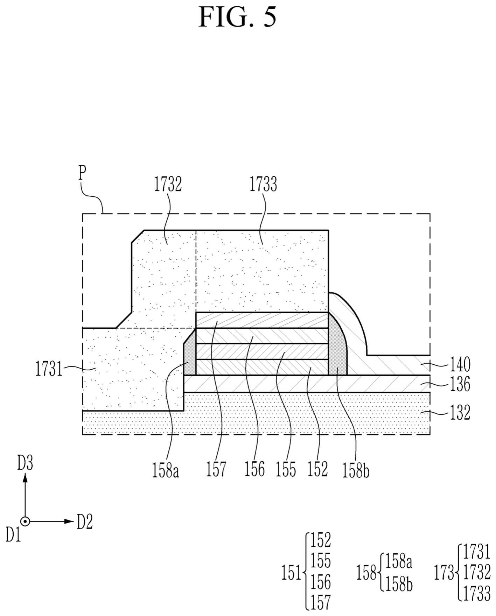

Fig. 5 is a cross-sectional view enlarging the P portion of Fig. 2, illustrating another implementation.

The implementation shown in Fig. 5 is similar to the implementation shown in Fig. 3, so the explanation for these parts will be omitted and the differences will be primarily explained. Additionally, the same reference numerals are used for components that are the same as in the preceding implementation.

Fig. 3 illustrates a case where the first protective layer 140 is positioned on at least a portion of the upper surface of the gate structure 151.

Referring to Fig. 5, the first protective layer 140 may not be positioned on the upper surface of the gate structure 151. The first protective layer 140 may be positioned on the second gate spacer 158b. The first protective layer 140 may not overlap (e.g., may not completely overlap) with the gate structure 151 in the third direction D3.

The gate structure 151 may have only a portion of the first hard mask layer 157 not covered by the first protective layer 140 and may not have a portion of the first hard mask layer 157 covered by the first protective layer 140. The entire upper surface of the first hard mask layer 157 may contact with the source electrode 173.

Since the first gate spacer 158a has an asymmetric shape with the second gate spacer 158b, and the upper level of the first gate spacer 158a may be lower than the upper level of the first hard mask layer 157, the side surface of the first hard mask layer 157 in the second direction D2 may not be covered by the first gate spacer 158a and may contact with the source electrode 173. For example, the side surface of the first hard mask layer 157 may contact with the side surface of the second portion 1732 of the source electrode 173.

For example, the first protective layer 140 may extend in the second direction D2 from one end of the upper surface of the gate structure 151 to contact with the drain electrode 175. In other words, one end in the second direction D2 of the first protective layer 140 may be positioned on the other end in the second direction D2 of the upper surface of the gate structure 151, and the other end in the second direction D2 of the first protective layer 140 may contact with the drain electrode 175. Accordingly, the first protective layer 140 may be positioned on the second gate spacer 158b and may cover the second gate spacer 158b. However, since the first protective layer 140 does not extend in the second direction D2 from the other end of the upper surface of the gate structure 151 toward the source electrode 173, the first protective layer 140 may not be positioned on the gate structure 151 and the first gate spacer 158a and may not cover the first gate spacer 158a. In other words, the first protective layer 140 may not overlap with the first gate spacer 158a in the third direction D3, but may overlap with the second gate spacer 158b in the third direction D3.

The source electrode 173 may have the first portion 1731, the second portion 1732, and the third portion 1733, and may not have the fourth portion 1734.

The first portion 1731 of the source electrode 173 may be positioned on one side in the second direction D2 of the gate structure 151 and may contact with the side surface in the second direction D2 of the first gate spacer 158a. The second portion 1732 of the source electrode 173 may be positioned on the first portion 1731 of the source electrode 173 and the first gate spacer 158a. The third portion 1733 of the source electrode 173 may be positioned on the gate structure 151. The third portion 1733 of the source electrode 173 may be positioned on the gate structure 151 that is not covered by the first protective layer 140.

Since the first protection layer 140 does not entirely cover (e.g., does not overlap) the upper surface of the gate structure 151, the source electrode 173 may not have the fourth portion 1734 positioned on the first protection layer 140. In some implementations, the source electrode 173 may be further extended in the second direction D2 toward the drain electrode 175 to cover the entire gate structure 151 and may also be positioned on the barrier layer 136 located between the gate structure 151 and the drain electrode 175. In this case, the source electrode 173 may have the fourth portion 1734, and the fourth portion 1734 of the source electrode 173 may function as a field dispersion layer.

The upper level of the second portion 1732 of the source electrode 173 may be higher than the upper level of the first portion 1731 of the source electrode 173, and may be equal to the upper level of the third portion 1733 of the source electrode 173. Accordingly, the source electrode 173 may have a step between the first portion 1731 and the second portion 1732, and may not have a step between the second portion 1732 and the third portion 1733.

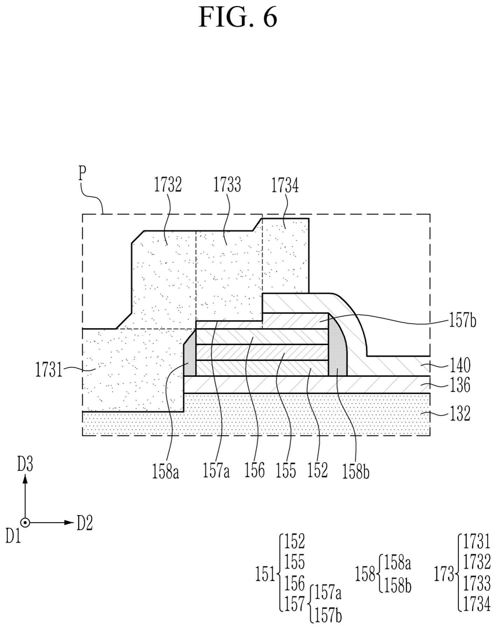

Fig. 6 is a cross-sectional view enlarging the P portion of Fig. 2, illustrating another implementation.

The implementation shown in Fig. 6 is similar to the implementation shown in Fig. 3, so the explanation for these parts will be omitted and the differences will be primarily explained. Additionally, the same reference numerals are used for components that are the same as in the preceding implementation.

Fig. 3 illustrates a case where the upper level of the portion 157b of the first hard mask layer 157 covered by the first protective layer 140 and the upper level of the portion 157a of the first hard mask layer 157 not covered by the first protective layer 140 are the same.

Referring to Fig. 6, the upper level of the portion 157a of the first hard mask layer 157 not covered by the first protective layer 140 may be lower than the upper level of the portion 157b of the first hard mask layer 157 covered by the first protective layer 140.

Here, the upper level of the portion 157a of the first hard mask layer 157 not covered by the first protective layer 140 may be, for example, the distance (e.g., the shortest distance) in the third direction D3 from the upper surface of the substrate 110 to the topmost part of the portion 157a of the first hard mask layer 157 not covered by the first protective layer 140. The upper level of the portion 157b of the first hard mask layer 157 covered by the first protective layer 140 may be, for example, the distance (e.g., the shortest distance) in the third direction D3 from the upper surface of the substrate 110 to the topmost part of the portion 157b of the first hard mask layer 157 covered by the first protective layer 140.

As described later with reference to Figs. 20 to 23, the first protective layer 140 may be formed, the first protective layer 140 positioned on the first gate spacer 158a may be removed using the second photoresist pattern 292 as an etching mask to expose the first gate spacer 158a, and the source electrode 173 may be formed to contact with the first gate spacer 158a at the removed position of the first protective layer 140. As the second photoresist pattern 292 is formed to cover at least a portion of the upper surface of the gate structure 151, a portion of the first protective layer 140 covering the upper surface of the gate structure 151 may be removed, a portion of the first protective layer 140 covering the first gate spacer 158a may be removed, and the first protective layer 140 covering the regions where the source electrode 173 and the drain electrode 175 are to be formed may be removed.

When a portion of the first protective layer 140 covering the upper surface of the gate structure 151 is removed, if the first protective layer 140 and the first hard mask layer 157 include materials with similar etch selectivity (e.g., low etch selectivity (e.g., similar etch rates)), a portion of the first hard mask layer 157 may be etched. In other words, the upper surface of portion 157a of the first hard mask layer 157, which is not covered by the first protective layer 140, may be partially etched. Accordingly, the upper level of portion 157a not covered by the first protective layer 140 may be lower than the upper level of portion 157b of the first hard mask layer 157 covered by the first protective layer 140.

One side surface in the second direction D2 of the portion 157b covered by the first protective layer 140 may contact with the second gate spacer 158b, and one side surface in the second direction D2 of the portion 157a not covered by the first protective layer 140 may contact with the side surface of the first gate spacer 158a or the second portion 1732 of the source electrode 173.

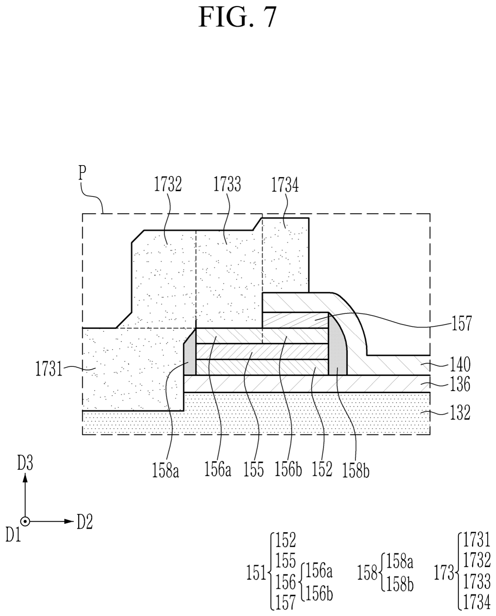

Fig. 7 is a cross-sectional view enlarging the P portion of Fig. 2, illustrating another implementation.

The implementation shown in Fig. 7 is similar to the implementation shown in Fig. 6, so the explanation for these parts will be omitted and the differences will be primarily explained. Additionally, the same reference numerals are used for components that are the same as in the preceding implementation.

Fig. 6 illustrates a case where the upper level of the portion 157a of the first hard mask layer 157 not covered by the first protective layer 140 is lower than the upper level of the portion 157b of the first hard mask layer 157 covered by the first protective layer 140.

Referring to Fig. 7, the first hard mask layer 157 does not have a portion 157a not covered by the first protective layer 140, and may only have a portion 157b covered by the first protective layer 140.

As described later with reference to Figs. 20 to 23, when a portion of the first protective layer 140, which covers the upper surface of the gate structure 151, is removed in order to form the source electrode 173, the first hard mask layer 157 may be etched if the first protective layer 140 and the first hard mask layer 157 include materials having similar etch selectivity (e.g., low etch selectivity (e.g., similar etch rates)). In this case, the entire portion 157a of the first hard mask layer 157 not covered by the first protective layer 140 may be etched. Accordingly, the first hard mask layer 157 may not have the portion 157a not covered with the first protective layer 140 and may only have the portion 157b covered with the first protective layer 140.

As the entire portion 157a of the first hard mask layer 157 not covered by the first protective layer 140 is etched, a part of the second hard mask layer 156 may be exposed. Even if the entire portion 157a of the first hard mask layer 157 not covered by the first protective layer 140 is etched, the second hard mask layer 156 may include a material having a etch selectivity relative to the first protective layer 140, so the second hard mask layer 156 may not be etched.

The second hard mask layer 156 may have a portion 156b covered by the first hard mask layer 157 and a portion 156a not covered by the first hard mask layer 157. The side surface in the second direction D2 of the portion 156b of the second hard mask layer 156 may contact with the second gate spacer 158b, and the side surface in the second direction D2 of the portion 156a of the second hard mask layer 156 may contact with the first gate spacer 158a.

The upper surface of the portion 156a of the second hard mask layer 156 not covered by the first hard mask layer 157 may contact with the source electrode 173. For example, the upper surface of the portion 156a of the second hard mask layer 156 not covered by the first hard mask layer 157 may contact with the lower surface of the third portion 1733 of the source electrode 173. In other words, the source electrode 173 may penetrate the first protective layer 140 and the first hard mask layer 157 to contact with the portion 156a of the second hard mask layer 156 not covered by the first hard mask layer 157.

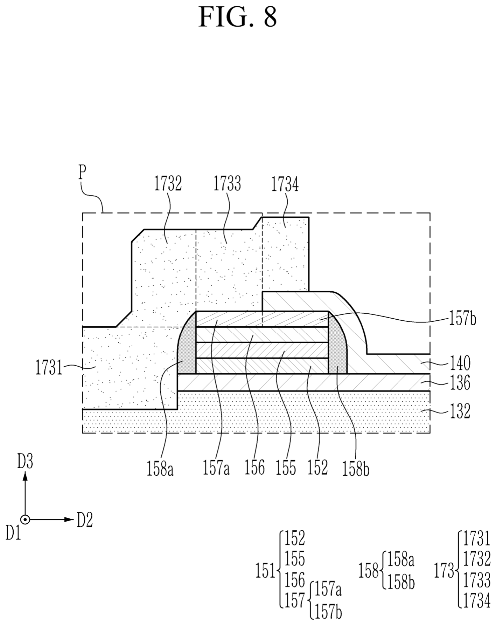

Fig. 8 is a cross-sectional view enlarging the P portion of Fig. 2, illustrating another implementation.

The implementation shown in Fig. 8 is similar to the implementation shown in Fig. 3, so the explanation for these parts will be omitted and the differences will be primarily explained. Additionally, the same reference numerals are used for components that are the same as in the preceding implementation.

Fig. 3 illustrates a case where the first gate spacer 158a and the second gate spacer 158b have different cross-sectional shapes.

Referring to Fig. 8, the first gate spacer 158a and the second gate spacer 158b may have the same cross-sectional shape. In other words, the first gate spacer 158a and the second gate spacer 158b may have a mirror-image shape that is symmetrical to each other.

As described later with reference to Figs. 20 to 23, the first protective layer 140 may be formed, the first protective layer 140 positioned on the first gate spacer 158a may be removed using the second photoresist pattern 292 as an etching mask to expose the first gate spacer 158a, and the source electrode 173 may be formed to contact with the first gate spacer 158a at the removed position of the first protective layer 140. When the first gate spacer 158a includes a material having a etch selectivity relative to the first protective layer 140, a portion of the first gate spacer 158a may not be etched when the first protective layer 140 is removed to expose the first gate spacer 158a. Therefore, the first gate spacer 158a may maintain a cross-sectional shape similar to that of the second gate spacer 158b. Accordingly, a first side surface in the second direction D2 of the first hard mask layer 157 may contact with the first gate spacer 158a, and a second side surface in the second direction D2 of the first hard mask layer 157 may contact with the second gate spacer 158b.

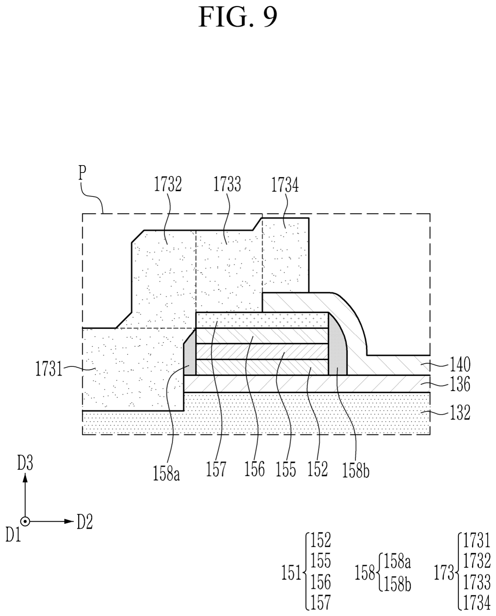

Fig. 9 is a cross-sectional view enlarging the P portion of Fig. 2, illustrating another implementation.

The implementation shown in Fig. 9 is similar to the implementation shown in Fig. 3, so the explanation for these parts will be omitted and the differences will be primarily explained. Additionally, the same reference numerals are used for components that are the same as in the preceding implementation.

Fig. 3 illustrates a case where the first hard mask layer 157 includes a material having etch selectivity similar to that of the first protective layer 140.

Referring to Fig. 9, the first hard mask layer 157 may include a metal material.

When the first hard mask layer 157 includes a metal material, the etch selectivity with respect to the gate spacer 158, the second hard mask layer 156, and the first protective layer 140 may be further increased. For example, when the gate spacer 158 includes silicon oxide, the first protective layer 140 includes silicon nitride, and the second hard mask layer 156 includes silicon oxide, if the first hard mask layer 157 includes a metal material, etch selectivity may be secured for all of the gate spacer 158, the second hard mask layer 156, and the first protective layer 140.

Accordingly, the material selectivity (e.g., etch selectivity) of the gate spacer 158, the second hard mask layer 156, and the first protective layer 140 may increase, allowing the gate electrode layer 155 to be protected during the formation of the gate spacer 158 and the etching of the first protective layer 140 to form the source electrode 173. Furthermore, as the first hard mask layer 157, which includes a metal material, is interposed between the gate electrode layer 155 and the source electrode 173, the capacitance may remain constant and may be easily adjusted because it is determined by a length in the second direction D2 of the gate electrode layer 155, irrespective of a length in the second direction D2 of the source electrode 173.

For example, the first hard mask layer 157 may include a metal material including titanium (Ti), titanium aluminum (TiAl), tantalum (Ta), tungsten (W), aluminum (Al), copper (Cu), cobalt (Co), nickel (Ni), platinum (Pt), nickel-platinum (Ni-Pt), niobium (Nb), molybdenum (Mo), ruthenium (Ru), rhodium (Rh), palladium (Pd), iridium (Ir), osmium (Os), silver (Ag), gold (Au), zinc (Zn), vanadium (V), or a combination thereof; a metal nitride including titanium nitride (TiN), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), molybdenum nitride (MoN), niobium nitride (NbN), titanium aluminum carbo-nitride (TiAIC-N), tantalum carbo-nitride (TaCN), or a combination thereof; and/or a metal carbide including titanium carbide (TiC), tantalum carbide (TaC), tungsten carbide (WC), niobium carbide (NbC), molybdenum carbide (MoC), titanium aluminum carbide (TiAIC), or a combination thereof.

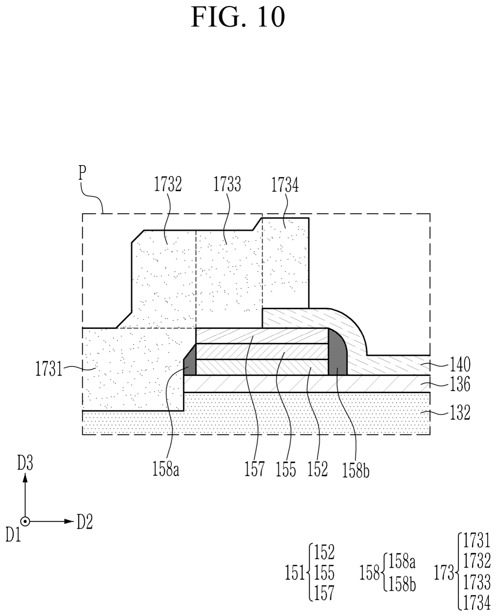

Fig. 10 is a cross-sectional view enlarging the P portion of Fig. 2, illustrating another implementation.

The implementation shown in Fig. 10 is similar to the implementation shown in Fig. 3, so the explanation for these parts will be omitted and the differences will be primarily explained. Additionally, the same reference numerals are used for components that are the same as in the preceding implementation.

Fig. 3 illustrates a case where the gate structure 151 includes the second hard mask layer 156.

Referring to Fig. 10, the gate structure 151 may not include the second hard mask layer 156. In other words, the gate structure 151 may consist of the gate semiconductor layer 152, the gate electrode layer 155, and the first hard mask layer 157 sequentially stacked.

In this case, the first hard mask layer 157 of the gate structure 151 may include a material having etch selectivity relative to the gate spacer 158 and the first protective layer 140.

Through this, the gate spacer 158 may be formed on the side surface of the gate structure 151, and during the etching process for forming the contact region of the source electrode 173, the gate electrode layer 155 may be prevented from being exposed and damaged.

For example, the gate spacer 158 and the first protective layer 140 may include silicon oxide. The first hard mask layer 157 may include a material having etch selectivity with the silicon oxide of the gate spacer 158 and the first protective layer 140, such as silicon nitride or metal material. In this case, the gate spacer 158 may be formed so as not to damage the gate electrode layer 155 positioned beneath the first hard mask layer 157. Furthermore, when etching the first protective layer 140 to form the source electrode 173, the first hard mask layer 157, as it is not etched during the etching of the first protective layer 140, may prevent the gate electrode layer 155 from being exposed and damaged. Additionally, the silicon oxide included in the gate spacer 158 and the silicon oxide included in the first protective layer 140 may have different etch selectivity (e.g., different etch rates) through oxidation number control, to prevent the gate spacer 158 from being removed when etching the first protective layer 140 to form the source electrode 173. That is, different silicon oxide layers may be controlled to have different etch rates through control of the relative oxygen content (e.g., stoichiometry) of the two layers (e.g., through control of the level of oxidation).

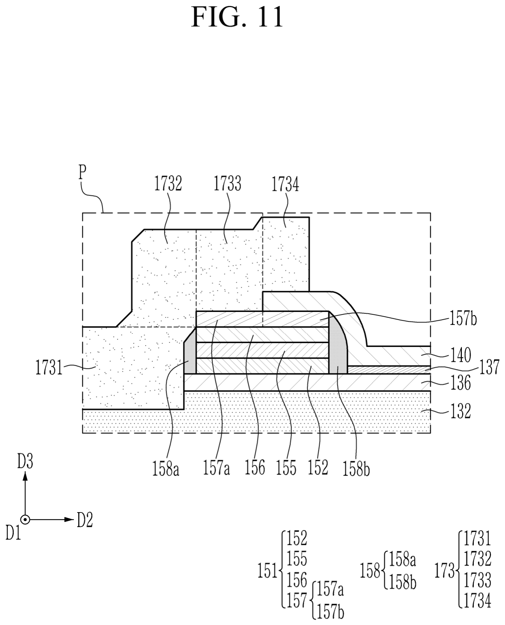

Fig. 11 is a cross-sectional view enlarging the P portion of Fig. 2, illustrating another implementation.

The implementation shown in Fig. 11 is similar to the implementation shown in Fig. 3, so the explanation for these parts will be omitted and the differences will be primarily explained. Additionally, the same reference numerals are used for components that are the same as in the preceding implementation.

Referring to Fig. 11, the semiconductor device may further include a second barrier layer 137.

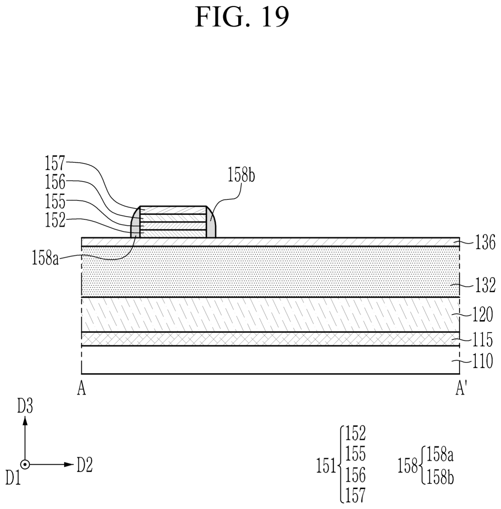

As described later in Fig. 19, after forming the gate spacer 158 on the side surface of the gate structure 151, the second barrier layer 137 may be further formed to cover a portion of the side surface of the gate spacer 158 on the barrier layer 136 (otherwise known as the first barrier layer 136).

The second barrier layer 137 may be positioned on the barrier layer 136. The second barrier layer 137 may be positioned between the barrier layer 136 and the first protective layer 140. The second barrier layer 137 may be positioned between the gate structure 151 and the drain electrode 175.

As described later with reference to Figs. 20 to 23, when a portion of the first protective layer 140 is removed to form the source electrode 173, the second photoresist pattern 292 is formed so as to cover at least a part of the upper surface of the gate structure 151, so a portion of the first protective layer 140 covering the upper surface of the gate structure 151 may be removed, a portion of the first protective layer 140 covering the first gate spacer 158a may be removed, and the first protective layer 140 covering the regions where the source electrode 173 and the drain electrode 175 will be formed may be removed. At this time, the second barrier layer 137 covering the regions where the source electrode 173 and the drain electrode 175 will be formed may be removed. Accordingly, the second barrier layer 137 is positioned on the region of the barrier layer 136 located between the gate structure 151 and the drain electrode 175, but the second barrier layer 137 may not be positioned on the region of the barrier layer 136 located between the gate structure 151 and the source electrode 173. In addition, the second barrier layer 137 may not be positioned on the upper surface of the gate structure 151. The second barrier layer 137 may not be positioned on the side surface of the first gate spacer 158a.

The second barrier layer 137 may be positioned on the side surface of the second gate spacer 158b. In other words, one end of the second direction D2 of the second barrier layer 137 may contact with the side surface of the second gate spacer 158b. The second barrier layer 137 may cover the side surface of the second gate spacer 158b by a length in the third direction D3 of the second barrier layer 137.

For example, the upper level of the second barrier layer 137 may be higher than the lower level of the gate spacer 158 and lower than the upper level of the gate spacer 158. Here, the upper level of the second barrier layer 137 may be the distance (e.g, the shortest distance) in the third direction D3 from the upper surface of the substrate 110 to the topmost part of the second barrier layer 137. The lower level of the gate spacer 158 may be the distance (e.g., the shortest distance) in the third direction D3 from the upper surface of the substrate 110 to the bottommost part of the gate spacer 158.

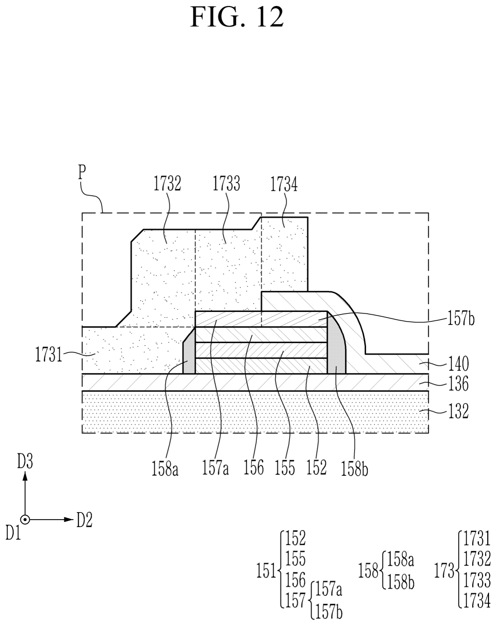

Fig. 12 is a cross-sectional view enlarging the P portion of Fig. 2, illustrating another implementation.

The implementation shown in Fig. 12 is similar to the implementation shown in Fig. 3, so the explanation for these parts will be omitted and the differences will be primarily explained. Additionally, the same reference numerals are used for components that are the same as in the preceding implementation.

Referring to Fig. 3, a part of the upper surface of the channel layer 132 is recessed, and the source electrode 173 and the drain electrode 175 may penetrate the barrier layer 136 to connect with the recessed channel layer 132.

Referring to Fig. 12, the channel layer 132 may not be recessed, and the source electrode 173 and the drain electrode 175 may be positioned on the upper surface of the channel layer 132. The bottom surface of the source electrode 173 and the drain electrode 175 may contact with the upper surface of the channel layer 132. For instance, the bottom surface of the source electrode 173 and the drain electrode 175 may be at the same level (e.g., may be coplanar with) the bottom surface of the barrier layer 136.

Additionally or alternatively, the barrier layer 136 may not be recessed, and the source electrode 173 and drain electrode 175 may be positioned on the upper surface of the barrier layer 136. In other words, the lower surface of the source electrode 173 and the drain electrode 175 may contact with the upper surface of the barrier layer 136. For instance, the bottom surface of the source electrode 173 and the drain electrode 175 may be at the same level as (e.g., may be coplanar with) the bottom surface of the first protective layer 140 (or at the same level as the bottom surface of the second barrier layer 137 if this is located between the first protective layer 140 and the barrier layer 136).

A portion of the channel layer 132 or the barrier layer 136 in contact with the source electrode 173 and the drain electrode 175 may be doped at a high concentration. At this time, the carrier that has passed through the two-dimensional electron gas 134 may be transferred to the source electrode 173 and the drain electrode 175 after passing on the portion of the channel layer 132 or barrier layer 136 that is doped at a high concentration, i.e., on the two-dimensional electron gas 134. The source electrode 173 and the drain electrode 175 may not directly contact with the two-dimensional electron gas 134 in the horizontal direction. The horizontal direction may mean a direction parallel to the upper surface of the channel layer 132 or the barrier layer 136.

Fig. 13 is a cross-sectional view taken along line A-A' of Fig. 1, illustrating another implementation.

The implementation shown in Fig. 13 is similar to the implementation shown in Fig. 2, so the explanation for these parts will be omitted and the differences will be primarily explained. Additionally, the same reference numerals are used for components that are the same as in the preceding implementation.

Fig. 2 illustrates a case where the source electrode 173 extends in the second direction D2 so that one end in the second direction D2 of the source electrode 173 is positioned on the gate structure 151. For example, the fourth portion 1734 of the source electrode 173 is positioned on the gate structure 151, not positioned on the second gate spacer 158b, and not positioned on the first protective layer 140 which is located between the gate structure 151 and the drain electrode 175.

Referring to Fig. 13, the source electrode 173 is further extended in the second direction D2 toward the drain electrode 175 to cover the entire gate structure 151, and may also be positioned on a portion of the barrier layer 136 located between the gate structure 151 and the drain electrode 175.

In this case, the source electrode 173 may function as a field dispersion layer 177. For example, the first portion 1731 of the source electrode 173 may be a lower source electrode, and the second to fourth portions 1732, 1733, 1734 of the source electrode 173 may be the field dispersion layer 177.

The field dispersion layer 177 may include first to third field dispersion layers. For example, the field dispersion layer 177 shown in Fig. 13 may show only the first field dispersion layer.

The first field dispersion layer may be positioned on the first protective layer 140. The first field dispersion layer may be positioned between the source electrode 173 and the drain electrode 175. The gate structure 151 may be covered by the first field dispersion layer. The first field dispersion layer may be electrically connected to the source electrode 173. For example, the first field dispersion layer may be connected to the lower source electrode.

The first field dispersion layer may include the same material as the lower source electrode and may be positioned in the same layer as the lower source electrode. The first field dispersion layer may be formed simultaneously in the same process as the lower source electrode. The boundary between the first field dispersion layer and the lower source electrode is not clear, and the first field dispersion layer may be integrated with the lower source electrode. However, it is not limited thereto, and the first field dispersion layer may also be a separate component separated from the lower source electrode. Furthermore, the first field dispersion layer may be positioned in a different layer than the lower source electrode and may be formed in a different process.

In some implementations, the first field dispersion layer may be electrically connected to the gate electrode layer 155. For example, an opening overlapping with the gate electrode layer 155 may be formed in the first protective layer 140, and the first field dispersion layer may be connected to the gate electrode layer 155 through the opening. In this case, the first field dispersion layer may not be connected to (e.g., may be insulated from) the source electrode 173.

The second field dispersion layer may be positioned on the second protective layer. The second field dispersion layer may constitute the field dispersion layer 177 together with the first field dispersion layer. The second field dispersion layer may be positioned between the source electrode 173 and the drain electrode 175. The second field dispersion layer may overlap with the gate electrode layer 155 in the third direction D3. The second field dispersion layer may overlap with the first field dispersion layer in the third direction D3. The gate electrode layer 155 and the first field dispersion layer may be covered by the second field dispersion layer. The second field dispersion layer may be wider than the width of the first field dispersion layer. The second field dispersion layer may entirely cover the first field dispersion layer. However, it is not limited thereto, and the width, positional relationship, etc., of the first field dispersion layer and the second field dispersion layer may be variously modified.

The second field dispersion layer may be electrically connected to the source electrode 173. For example, the second field dispersion layer may be connected to the intermediate source electrode. The second field dispersion layer may include the same material as the intermediate source electrode, and may be positioned in the same layer as the intermediate source electrode. The second field dispersion layer may be formed simultaneously with the intermediate source electrode in the same process as the intermediate source electrode. The boundary between the second field dispersion layer and the intermediate source electrode is not clear, and the second field dispersion layer may be integrated with the intermediate source electrode. However, it is not limited thereto, and the second field dispersion layer may be a separate component separated from the intermediate source electrode. Additionally, the second field dispersion layer may be positioned in a different layer from the intermediate source electrode and may be formed in a different process.

The third field dispersion layer may be positioned on the third protective layer. The third field dispersion layer, together with the first and second field dispersion layers, may constitute the field dispersion layer 177. The third field dispersion layer may be positioned between the source electrode 173 and the drain electrode 175. The third field dispersion layer may overlap with the gate electrode layer 155 in the third direction D3. The third field dispersion layer may overlap with the first and second field dispersion layers in the third direction D3. The gate electrode layer 155, the first field dispersion layer, and the second field dispersion layer may be covered by the third field dispersion layer. The third field dispersion layer may have a larger width than the second field dispersion layer. The third field dispersion layer may entirely cover the second field dispersion layer. However, it is not limited thereto, and the width, positioning relations, and other characteristics of the first, second, and third field dispersion layers may be variously modified.

The third field dispersion layer may be electrically connected to the source electrode 173. For example, the third field dispersion layer may be connected to the upper source electrode. The third field dispersion layer may include the same material as the upper source electrode and may be positioned in the same layer with the upper source electrode. The third field dispersion layer may be formed simultaneously in the same process as the upper source electrode. The boundary between the third field dispersion layer and the upper source electrode is not clear, and the third field dispersion layer may be integrated with the upper source electrode. However, it is not limited thereto, as the third field dispersion layer may also be a separate component separated from the upper source electrode. Additionally, the third field dispersion layer may be positioned in a different layer from the upper source electrode and may be formed in a different process.

In some implementations, at least one of the first field dispersion layer, the second field dispersion layer, or the third field dispersion layer may be omitted. For example, the semiconductor device may include the first field dispersion layer and may not include the second field dispersion layer or the third field dispersion layer. Alternatively, the semiconductor device may include the second field dispersion layer and may not include the first field dispersion layer or the third field dispersion layer. Alternatively, the semiconductor device may include the third field dispersion layer and may not include the first field dispersion layer or the second field dispersion layer. Alternatively, the semiconductor device may not include the first field dispersion layer, the second field dispersion layer, and the third field dispersion layer.

The field dispersion layer 177 may serve to disperse an electric field concentrated around the gate electrode layer 155. Specifically, in the gate-off state, a portion of the channel layer 132 positioned between the gate electrode layer 155 and the source electrode 173, and a portion of the channel layer 132 positioned between the gate electrode layer 155 and the drain electrode 175, may have the two-dimensional electron gas 134 at a very high concentration. In this case, an electric field may be concentrated on the gate electrode layer 155 or the gate semiconductor layer 152. On the other hand, the gate electrode layer 155 and the gate semiconductor layer 152 are vulnerable to electric fields, and when the electric field is concentrated, the leakage current may increase and the breakdown voltage of the semiconductor device may decrease. The semiconductor device may have a field dispersion layer 177 in which the electric field concentrated around the gate electrode layer 155 or the gate semiconductor layer 152 is dispersed, thereby reducing leakage current and increasing breakdown voltage.

Hereinafter, a method of manufacturing a semiconductor device will be described with reference to Figs. 14 to 24. Additionally, Figs. 1 to 3, described earlier, may also be referred to. Figs. 14 to 24 are cross-sectional views illustrating a method of manufacturing a semiconductor device in process order, corresponding to Fig. 2.

Referring to Fig. 14, a seed layer 115, a buffer layer 120, a channel layer 132, and a barrier layer 136 may be sequentially formed on the substrate 110.

For example, the seed layer 115, the buffer layer 120, the channel layer 132, and the barrier layer 136 may be formed sequentially using epitaxial growth. The seed layer 115 may first be formed on a substrate 110, and the buffer layer 120 may be formed on the seed layer 115. The buffer layer 120 may include a superlattice layer and a high resistance layer. The channel layer 132 may be formed on the buffer layer 120, and the barrier layer 136 may be formed on the channel layer 132.

For example, equipment for growing the seed layer 115, the buffer layer 120, the channel layer 132, and the barrier layer 136 may utilize metal organic chemical vapor deposition (MOCVD), hydride vapor phase epitaxy (HVPE), or molecular beam epitaxy (MBE).

The seed layer 115, the buffer layer 120, the channel layer 132, and the barrier layer 136 may be formed of semiconductor material of the same basis. However, the compositional ratio of the material in each layer may vary, considering factors such as the function of each layer and the performance required for the semiconductor device.

For example, the substrate 110 may include Si, the seed layer 115 may include AIN, and the superlattice layer of the buffer layer 120 may have a structure in which a layer formed of AlGaN and a layer formed of GaN are repeatedly stacked. The high resistance layer of the buffer layer 120 may include GaN, the channel layer 132 may include GaN, and the barrier layer 136 may include AlGaN. The channel layer 132 and the barrier layer 136 may or may not be doped with impurities.

The lattice structure of Si and the lattice structure of GaN are different, making it difficult to directly grow the channel layer 132 made of GaN right above the substrate 110 made of Si. Therefore, by first forming the seed layer 115 or the buffer layer 120 on the substrate 110, and then forming the channel layer 132, the lattice structure of the channel layer 132 may be formed stably.

Next, a gate semiconductor material layer 152L, a gate electrode material layer 155L, a second hard mask material layer 156L, and a first hard mask material layer 157L may be sequentially formed on the barrier layer 136. The gate semiconductor material layer 152L may include GaN and may be doped with impurities. The gate semiconductor material layer 152L may be doped with p-type impurities, for example, magnesium (Mg).

For example, the gate semiconductor material layer 152L may be formed using metal-organic chemical vapor deposition (MOCVD), hydride vapor phase epitaxy (HVPE), or molecular beam epitaxy (MBE).

The gate electrode material layer 155L may be formed using a deposition process. For example, the gate electrode material layer 155L may be formed using E-beam evaporation, sputtering, physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD), among others.

The second hard mask material layer 156L and the first hard mask material layer 157L may be spin-on hardmask layers (SOH). The spin-on hardmask layers may be formed on the gate electrode material layer 155L through a spin coating process.

For example, the first hard mask material layer 157L and the second hard mask material layer 156L may independently include an insulating material, metal material, metal nitride, metal carbide, dielectric material, semiconductor material, or a combination thereof. In this case, the first hard mask material layer 157L and the second hard mask material layer 156L may include materials with different etch selectivities (e.g., with etch selectivity relative to each other).

The insulating material may include, for example, silicon oxide, silicon oxynitride, silicon carbon oxynitride, silicon nitride, or a combination thereof. The metal material may include titanium (Ti), titanium aluminum (TiAl), tantalum (Ta), tungsten (W), aluminum (Al), copper (Cu), cobalt (Co), nickel (Ni), platinum (Pt), nickel platinum (Ni-Pt), niobium (Nb), molybdenum (Mo), ruthenium (Ru), rhodium (Rh), palladium (Pd), iridium (Ir), osmium (Os), silver (Ag), gold (Au), zinc (Zn), vanadium (V), or a combination thereof. The metal nitride may include titanium nitride (TiN), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), molybdenum nitride (MoN), niobium nitride (NbN), titanium aluminum carbonitride (TiAIC-N), tantalum carbonitride (TaCN), or a combination thereof. The metal carbide may include titanium carbide (TiC), tantalum carbide (TaC), tungsten carbide (WC), niobium carbide (NbC), molybdenum carbide (MoC), titanium aluminum carbide (TiAIC), or a combination thereof. The dielectric material may include hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalate oxide, lead zinc niobate, or a combination thereof. The semiconductor material may include Si, AIN, GaN, InN, InGaN, AlGaN, AllnN, AlinGaN, or a combination thereof.

In some implementations, a third hard mask material layer may be further formed on the first hard mask material layer 157L. The third hard mask material layer may be a spin-on hard mask material layer (SOH) and may be formed on the first hard mask material layer 157L via a spin coating process. The third hard mask material layer may include a material having etch selectivity relative to the first hard mask material layer 157L. For example, when the first hard mask material layer 157L includes silicon nitride, the third hard mask material layer may include silicon oxide. The third hard mask material layer may be removed together when partially removing the gate spacer material layer while forming the gate spacer 158 described later.

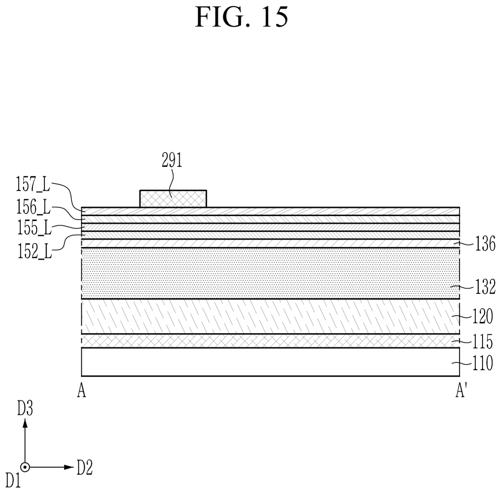

Referring to Fig. 15, a first photoresist pattern 291 may be formed on the first hard mask material layer 157L.

A photoresist composition may be coated on the first hard mask material layer 157L to form a photoresist layer. For example, the photoresist layer may be formed by applying the photoresist composition on the first hard mask material layer 157L using methods such as spin coating, spray coating, dip coating, knife edge coating, or by printing methods like inkjet printing, screen printing, etc., and then drying the applied photoresist composition.

The photoresist layer may be selectively exposed and removed by dissolving the photoresist layer corresponding to an unexposed region or an exposed region using a developer, thus forming a first photoresist pattern 291. For example, the region masked by the first photoresist pattern 291 may be a region where the gate structure 151 will be formed later, and the region exposed by the first photoresist pattern 291 may include the regions where the source electrode 173 and the drain electrode 175 will be formed later.

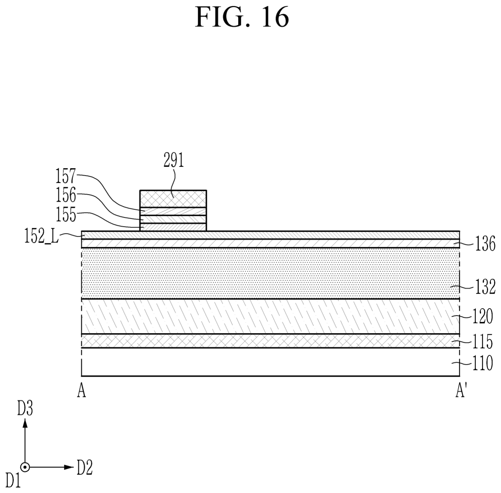

Referring to Fig. 16, by using the first photoresist pattern 291 as the etching mask, the first hard mask material layer 157L may be etched to form the first hard mask layer 157, the second hard mask material layer 156L may be etched to form the second hard mask layer 156, and the gate electrode material layer 155L may be etched to form the gate electrode layer 155.

The etching of the first hard mask material layer 157L, the second hard mask material layer 156L, and the gate electrode material layer 155L may be performed by dry etching using an etching gas. The etching gas may include a fluoride gas or a chloride gas. The fluoride gas may include, for example, SF₆, CHF₃, CF₄, or a mixed gas thereof, and the chloride gas may include Cl₂, BCl₃, or a mixed gas thereof. For example, the first hard mask material layer 157L, the second hard mask material layer 156L, and the gate electrode material layer 155L may be etched using SF₆ gas.

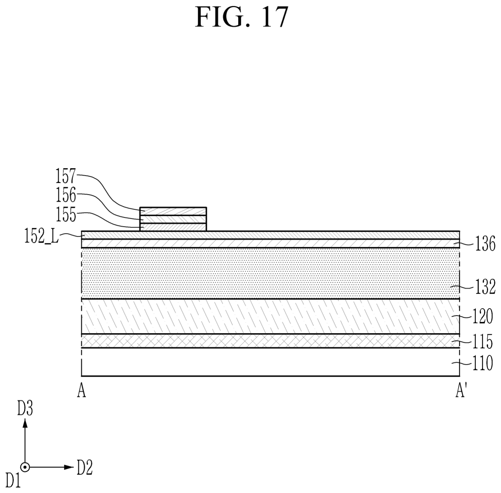

Referring to Fig. 17, the first photoresist pattern 291 may be removed.

For example, the removal of the first photoresist pattern 291 may be perfomed through an ashing and/or stripping process. The ashing process and stripping process may proceed sequentially. That is, the ashing process, which removes the upper portion of the first photoresist pattern 291 first through an oxygen (O₂) plasma treatment process or an ozone (O₃) treatment process, may be performed, and then a stripping process may be performed.

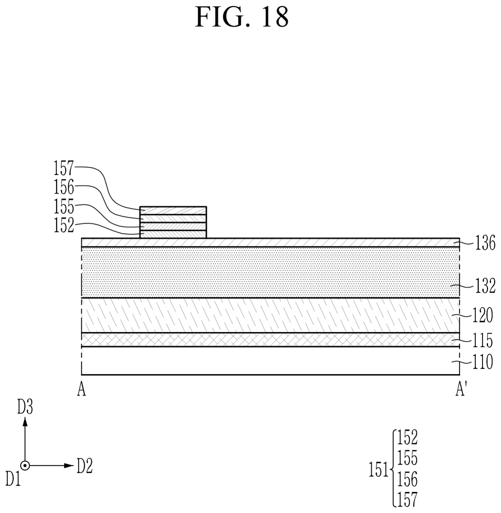

Referring to Fig. 18, the gate semiconductor layer 152 may be formed by etching the gate semiconductor material layer 152L using the first hard mask layer 157 as an etching mask.

Etching of the gate semiconductor material layer 152L may be performed by dry etching using etching gas. The gate semiconductor material layer 152L may be etched using a mixed gas of Cl₂ and O₂ or a mixed gas of BCL₃ and SF₆.

By forming the gate semiconductor layer 152, the gate structure 151 including the gate semiconductor layer 152, the gate electrode layer 155, the second hard mask layer 156, and the first hard mask layer 157 may be formed.

In some implementations, after forming the gate semiconductor layer 152, a treatment process for reducing damage to the barrier layer 136 due to by-product removal and dry etching may be performed. For example, the by-product removal may be carried out through an ashing process and/or a stripping process. The ashing process and the stripping process may be conducted sequentially. For example, after performing an ashing process via an oxygen (O₂) plasma treatment process or an ozone (O₃) treatment process, a stripping process may be conducted. Separately from the ashing process or stripping process, dry and wet treatment processes may be performed. For example, the treatment process may include, for example, a dry cleaning using N₂O plasma, N₂ plasma, NH₃ plasma, or O₂ plasma, or a wet cleaning process using diluted HF (DHF), BOE, or ammonia water (NH₄OH).

Referring to Fig. 19, the gate spacer 158 is formed on the side surface of the gate structure 151.

A gate spacer material layer may be formed to cover the upper surface of the barrier layer 136, the side surface of the gate semiconductor layer 152, the side surface of the gate electrode layer 155, the side surface of the second hard mask layer 156, the side surface of the first hard mask layer 157, and the upper surface of the first hard mask layer 157. The gate spacer material layer may be formed with a uniform thickness.

For example, the gate spacer material layer may be formed using metal-organic chemical vapor deposition (MOCVD), hydride vapor phase epitaxy (HVPE), or molecular beam epitaxy (MBE), among others.

Anisotropic etching, for example, an etch-back process, may be perfomed on the gate spacer material layer to leave the gate spacer material layer covering the side surfaces of the gate structure 151 and to selectively remove the gate spacer material layer covering the upper surface of the gate structure 151 and the upper surface of the barrier layer 136 so that a pair of gate spacers 158 may be formed on the side surfaces of the gate structure 151.

The gate spacer 158 may include the first gate spacer 158a positioned on one side surface of the gate structure 151 and the second gate spacer 158b positioned on the other side surface of the gate structure 151.

At this time, the gate spacer 158 may include a material having etch selectivity relative to the first hard mask layer 157. Through this, it is possible to prevent the gate electrode layer 155 from being exposed and damaged during the process of forming the gate spacer 158 on the side surface of the gate structure 151. For example, the first hard mask layer 157 may include silicon nitride or a metal material, and the gate spacer 158 may include silicon oxide.

In this case, by using an etching gas including SF₆ during the etching of the gate spacer material layer, the etch selectivity between the first hard mask layer 157 and the gate spacer 158 may be increased, and the damage to the barrier layer 136 positioned below the spacer material layer may also be minimized.

Referring to Fig. 20, in some implementations, after forming the gate spacer 158 on the side surface of the gate structure 151, the second barrier layer 137 may be further formed to cover a portion of the side surfaces of the gate spacer 158 on the barrier layer 136.

For example, equipment for growing the second barrier layer 137 may include metal-organic chemical vapor deposition (MOCVD), hydride vapor phase epitaxy (HVPE), or molecular beam epitaxy (MBE).

The second barrier layer 137 may be formed to be positioned on the barrier layer 136, and may not be formed on the gate structure 151 and the gate spacer 158.

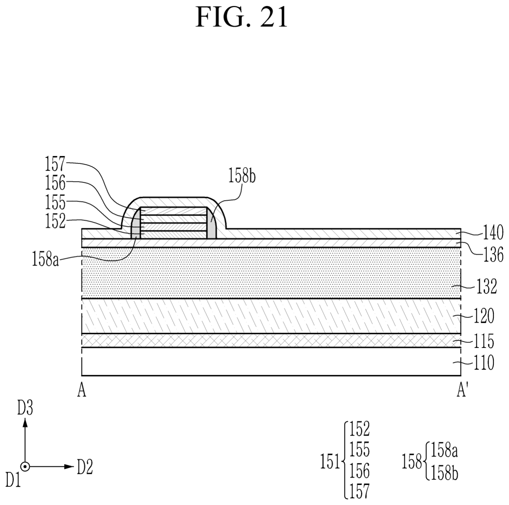

As described later with reference to Figs. 21 to 24, when removing a portion of the first protective layer 140 to form the source electrode 173, the second photoresist pattern 292 is formed to cover from at least part of the upper surface of the gate structure 151 to the region where the drain electrode 175 will be formed. Consequently, the region where the source electrode 173 and the drain electrode 175 will be formed, and the second barrier layer 137 covering from at least part of the upper surface of the gate structure 151 to the region where the source electrode 173 will be formed, may be removed. Thus, the second barrier layer 137 is positioned on the region of the barrier layer 136 located between the gate structure 151 and the drain electrode 175, but the second barrier layer 137 may not be positioned on the region of the barrier layer 136 located between the gate structure 151 and the source electrode 173.

The second barrier layer 137 may be positioned on the side surface of the second gate spacer 158b. In other words, one end in the second direction D2 of the second barrier layer 137 may contact with the side surface of the second gate spacer 158b. The second barrier layer 137 may cover the side surface of the second gate spacer 158b by a length in the third direction D3 of the second barrier layer 137.

Referring to Fig. 21, the first protective layer 140 may be formed on the barrier layer 136, the gate structure 151, and the gate spacer 158.

The first protective layer 140 may be formed using a deposition process. Although the first protective layer 140 is illustrated as a single layer, it may be formed as multiple layers depending on the circumstances. In this case, the first protective layer 140 may be formed by sequentially depositing different materials. Alternatively, it may be formed as multiple layers with different characteristics by altering the deposition conditions using the same material. In particular, the portion of the first protective layer 140 adjacent to the barrier layer 136 may be made of insulating material with higher (e.g., much higher) quality compared to other portions. This is to prevent electrons forming a channel from being trapped in the channel layer 132 positioned under the barrier layer 136. The portion of the first protective layer 140 in contact with the barrier layer 136 may be made of silicon oxide.

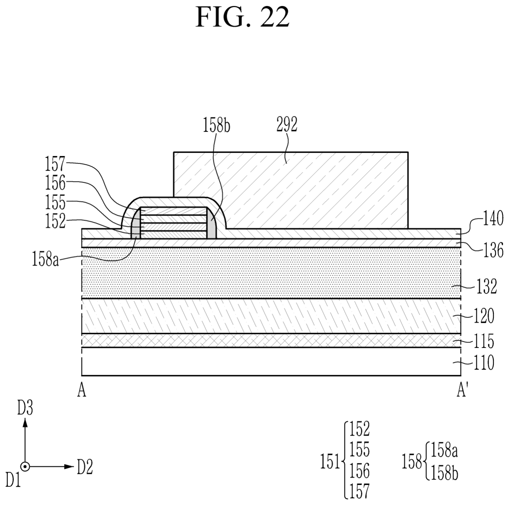

In this case, the first protective layer 140 and the gate spacer 158 may include materials having etch selectivity relative to each other. In addition, the first protective layer 140 may include materials having etch selectivity relative to the second hard mask layer 156. Through this, as described later in FIGS. 22 to 24, when the first protective layer 140 positioned on the first gate spacer 158a is removed using the second photoresist pattern 292 as an etch mask to expose the first gate spacer 158a, only the first protective layer 140 may be removed and the first gate spacer 158a may not be removed. Additionally, since the second hard mask layer 156 is not etched during the etching of the first protective layer 140, the gate electrode layer 155 may be prevented from being exposed and damaged. For example, the first protective layer 140 may include silicon nitride, and the gate spacer 158 and the second hard mask layer 156 may include silicon oxide.

Referring to Fig. 22, a second photoresist pattern 292 may be formed on the first protective layer 140.

A photoresist composition may be coated on the first protective layer 140 to form a photoresist layer. For example, the photoresist layer may be formed by applying the photoresist composition onto the first protective layer 140 using methods such as spin coating, spray coating, dip coating, knife edge coating, or by using printing methods such as inkjet printing or screen printing, and then drying the applied photoresist composition.

The photoresist layer may be selectively exposed, and the photoresist layer corresponding to the unexposed region or the exposed region may be dissolved and removed using a developer solution to form the second photoresist pattern 292. The region exposed by the second photoresist pattern 292 may be a region where the source electrode 173 and the drain electrode 175 will be subsequently formed.

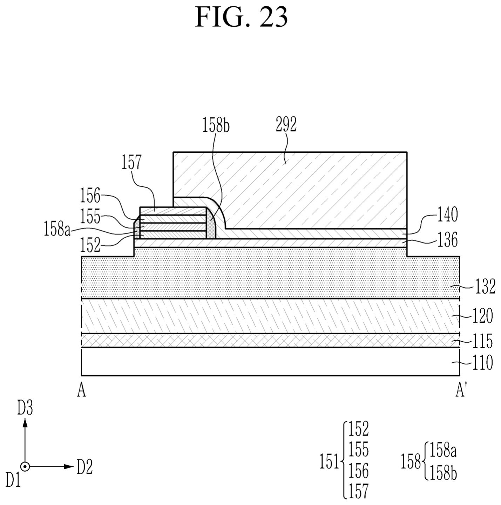

For example, the second photoresist pattern 292 may be positioned on at least a portion of the upper surface of the gate structure 151. The second photoresist pattern 292 may extend in the second direction D2 from at least a portion of the upper surface of the gate structure 151 to the region where the drain electrode 175 will be formed. In other words, one end in the second direction D2 of the second photoresist pattern 292 is positioned on the upper surface of the gate structure 151, and the other end in the second direction D2 of the second photoresist pattern 292 may contact with the region where the drain electrode 175 will be formed. Accordingly, the second photoresist pattern 292 is positioned on the second gate spacer 158b and may cover the second gate spacer 158b. However, since the second photoresist pattern 292 does not extend all the way to the region where the source electrode 173 will be formed from at least a portion of the upper surface of the gate structure 151, the second photoresist pattern 292 is not positioned on the first gate spacer 158a and may not cover the first gate spacer 158a. Accordingly, the region where the source electrode 173 will be formed may be formed in contact with the first gate spacer 158a, and, as described later in Figs. 23 to 24, the source electrode 173 may be formed in contact with the first gate spacer 158a.

In some implementations, the second photoresist pattern 292 may cover the upper surface of the gate structure 151 completely. The second photoresist pattern 292 may extend in the second direction D2 from one end of the upper surface of the gate structure 151 to the region where the drain electrode 175 will be formed. In other words, one end of the second photoresist pattern 292 in the second direction D2 is positioned on one end of the upper surface of the gate structure 151 in the second direction D2, and the other end of the second photoresist pattern 292 in the second direction D2 may contact with the region where the drain electrode 175 will be formed. Accordingly, the second photoresist pattern 292 is positioned on the second gate spacer 158b and may cover the second gate spacer 158b. However, the second photoresist pattern 292 does not extend from one end of the upper surface of the gate structure 151 in the second direction D2 toward the source electrode 173, and therefore, the second photoresist pattern 292 is not positioned on the first gate spacer 158a and may not cover the first gate spacer 158a.

Referring to Fig. 23, the first protective layer 140 positioned on the first gate spacer 158a may be removed using the second photoresist pattern 292 as an etching mask to expose the first gate spacer 158a.

The barrier layer 136 may also be patterned when etching the first protective layer 140, and the channel layer 132 may be recessed to a certain depth.

Etching of the first protective layer 140 may be performed by dry etching using etching gas. The etching gas may include fluoride gas or chloride gas. For example, the fluoride gas may include SF₆, CHF₃, CF₄, or a mixed gas thereof, and the chloride gas may include Cl₂, BCl₃, or a mixed gas thereof.

For example, when the second photoresist pattern 292 is positioned on at least a portion of the upper surface of the gate structure 151, if the first protective layer 140 is removed using the second photoresist pattern 292 as an etching mask, the first protective layer 140 may be positioned on a portion of the upper surface of the gate structure 151, as illustrated in Fig. 3.

In some implementations, when the second photoresist pattern 292 covers the entire upper surface of the gate structure 151, if the first protective layer 140 is removed using the second photoresist pattern 292 as an etching mask, the first protective layer 140 may cover the entire upper surface of the gate structure 151, as illustrated in Fig. 4.

Alternatively, if the second photoresist pattern 292 is not positioned on the upper surface of the gate structure 151, and if the first protective layer 140 is removed using the second photoresist pattern 292 as an etching mask, the first protective layer 140 may not be positioned on the upper surface of the gate structure 151, and the first protective layer 140 may be positioned on the second gate spacer 158b, as illustrated in Fig. 5.

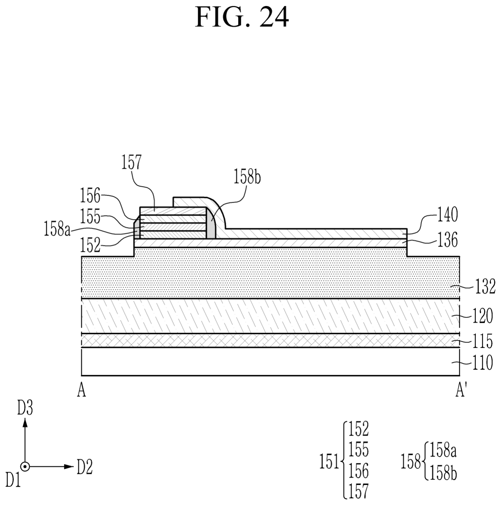

Referring to Fig. 24, the second photoresist pattern 292 may be removed.

For example, the removal of the second photoresist pattern 292 may be performed through an ashing and/or stripping process. The ashing process and stripping process may proceed sequentially. That is, an ashing process for removing the upper portion of the second photoresist pattern 292 may first be performed through an oxygen (O₂) plasma treatment process or an ozone (O₃) treatment process, and then the stripping process may be performed.

Referring again to Figs. 1 to 3, the source electrode 173 and the drain electrode 175 may be formed at the region(s) where the first protective layer 140 is removed.

For example, by forming the second photoresist pattern 292 to be positioned on at least part of the upper surface of the gate structure 151, when a portion of the first protective layer 140 is removed using the second photoresist pattern 292 as an etching mask, the first gate spacer 158a is exposed, allowing the source electrode 173 to be formed in contact with the first gate spacer 158a. The source electrode 173 and the drain electrode 175 may be formed by forming an electrode layer and subsequently patterning the electrode layer to form the source electrode 173 and the drain electrode 175.

In some aspects, the present disclosure provides a method of manufacturing a semiconductor device including forming a channel layer on a substrate, forming a barrier layer on the channel layer, forming a gate structure including a gate semiconductor layer positioned on the barrier layer, a gate electrode layer positioned on the gate semiconductor layer, and a first hard mask layer positioned on the gate electrode layer, forming gate spacers on a side surface of the gate structure, and forming a source electrode in contact with the gate spacers.

In some implementations, the first hard mask layer and the gate spacer may include materials with different etch selectivities (e.g., having etch selectivity relative to each other).

In some implementations, the gate structure may include a second hard mask layer positioned between the gate electrode layer and the first hard mask layer.

In some implementations, the first hard mask layer and the second hard mask layer may include materials having different etch selectivities from each other (e.g., having etch selectivity relative to each other).

In some implementations, forming the gate structure may include forming a gate semiconductor material layer, a gate electrode material layer, a second hard mask material layer, and a first hard mask material layer on the barrier layer, forming a first photoresist pattern on the first hard mask material layer, etching the first hard mask material layer using the first photoresist pattern as an etching mask to form the first hard mask layer, etching the second hard mask material layer to form the second hard mask layer, etching the gate electrode material layer to form the gate electrode layer, removing the first photoresist pattern, and etching the gate semiconductor material layer using the first hard mask layer as an etching mask to form the gate semiconductor layer.

In some implementations, forming the gate spacer may include forming a gate spacer material layer covering an upper surface and a side surface of the gate structure, and selectively removing the gate spacer material layer covering the upper surface of the gate structure while leaving the gate spacer material layer covering the side surface of the gate structure.

In some implementations, after forming the gate spacer, a second barrier layer may be further formed on the barrier layer to cover a portion of the side surface of the gate spacer.

In some implementations, the gate spacer may include a first gate spacer positioned on one side surface of the gate structure, and a second gate spacer positioned on the other side surface of the gate structure.

In some implementations, forming the source electrode may include forming a first protective layer covering the barrier layer, the gate structure, and the gate spacer, forming a second photoresist pattern on the first protective layer to be positioned on the second gate spacer and not on the first gate spacer, and removing the first protective layer positioned on the first gate spacer using the second photoresist pattern as an etching mask to expose the first gate spacer, and forming the source electrode in a position where the first protective layer is removed, in contact with the first gate spacer.

The semiconductor device according to implementations of the present disclosure provides a stable device with low resistance by easily adjusting the capacitance between the gate electrode layer and the source electrode, minimizing the gap between the gate electrode layer and the source electrode, and resolving the resulting misalignment problem of the source electrode.

Embodiments are set out in the following Clauses:
Clause 1. A semiconductor device comprising:
   a channel layer;
   a barrier layer on the channel layer;
   a gate structure comprising (i) a gate semiconductor layer on the barrier layer and (ii) a gate electrode layer on the gate semiconductor layer;
   a gate spacer on at least one side surface of the gate structure; and
   a source electrode and a drain electrode that are (i) spaced apart from each other with the gate structure therebetween and (ii) connected to the channel layer,
   wherein the source electrode contacts the gate spacer.
Clause 2. The semiconductor device of Clause 1, wherein the gate spacer comprises (i) a first gate spacer on a first side surface of the gate structure and (ii) a second gate spacer on a second side surface of the gate structure,
   wherein the first gate spacer is between the gate structure and the source electrode,
   wherein the first gate spacer contacts the source electrode, and
   wherein, in a cross-section perpendicular to an extending direction of the gate structure, the first gate spacer and the second gate spacer have different shapes.
Clause 3. The semiconductor device of Clause 2, wherein an upper level of the first gate spacer is lower than an upper level of the second gate spacer, and
   wherein a width of the first gate spacer is less than a width of the second gate spacer.
Clause 4. The semiconductor device of Clause 3, wherein the gate structure comprises a first hard mask layer on the gate electrode layer, and
   wherein a side surface of the first hard mask layer contacts the source electrode.
Clause 5. A semiconductor device comprising:
   a channel layer;
   a barrier layer on the channel layer;
   a gate structure comprising (i) a gate semiconductor layer on the barrier layer, (ii) a gate electrode layer on the gate semiconductor layer, and (iii) a first hard mask layer on the gate electrode layer;
   a gate spacer on at least one side surface of the gate structure; and
   a source electrode and a drain electrode that are (i) spaced apart from each other with the gate structure therebetween and (ii) connected to the channel layer,
   wherein the first hard mask layer and the gate spacer comprise materials with different etching selectivities, and
   wherein the first hard mask layer comprises a metal material.

The above detailed description of the implementations of the present disclosure is not intended to limit the scope of the present disclosure. Rather, various modifications and improvements made by a person of ordinary skill in the art using the basic concepts of the present disclosure as defined in the following claims also fall within the scope of the present disclosure.

## Claims

1. A semiconductor device comprising:
a channel layer (132);
a barrier layer (136) on the channel layer (132);
a gate structure comprising a gate semiconductor layer (152) on the barrier layer (136), a gate electrode layer (155) on the gate semiconductor layer (152), a second hard mask layer (156) on the gate electrode layer (155), and a first hard mask layer (157) on the second hard mask layer (156);
a gate spacer (158) on at least one side surface of the gate structure; and
a source electrode (173) and a drain electrode (175) that are spaced apart from each other with the gate structure therebetween and that are connected to the channel layer (132),
wherein the first hard mask layer (156) and the gate structure comprise materials having different etch selectivities, and
wherein the first hard mask layer (156) and the second hard mask layer (157) comprise materials having different etch selectivities.

2. The semiconductor device of claim 1, wherein the gate spacer (158) comprises a first gate spacer (158a) on a first side surface of the gate structure and a second gate spacer (158b) on a second side surface of the gate structure,
wherein the first gate spacer (158a) is between the gate structure and the source electrode (173), and
wherein the first gate spacer (158a) contacts the source electrode (173).

3. The semiconductor device of claim 2, wherein the semiconductor device comprises a first protective layer (140) on the barrier layer (136), and
wherein the first protective layer (140) is on the second gate spacer (158b) and is offset from the first gate spacer (158a).

4. The semiconductor device of claim 3, wherein the first protective layer (140) is on at least a portion of an upper surface of the gate structure.

5. The semiconductor device of claim 4, wherein an upper level of the first hard mask layer (157) is higher than the upper level of the first gate spacer (158a),
wherein the upper level of the first hard mask layer (157) is higher than or equal to an upper level of the second gate spacer (158b), and
wherein the upper level of the first hard mask layer (157) is lower than an upper level of the first protective layer (140).

6. The semiconductor device of any of claims 3-5, wherein the first protective layer (140) covers an entire upper surface of the gate structure.

7. The semiconductor device of any of claims 3-5, wherein the first protective layer (140) is offset from an upper surface of the gate structure.

8. The semiconductor device of any of claims 3-5, wherein the first hard mask layer (157) comprises a first portion covered by the first protective layer (140) and a second portion being free from the first protective layer (140), and
wherein the second portion of the first hard mask layer contacts the source electrode (173).

9. The semiconductor device of claim 8, wherein an upper level of the second portion of the first hard mask layer (157) is lower than or equal to an upper level of the first portion of the first hard mask layer (157).

10. The semiconductor device of any of claims 3-5, wherein the first hard mask layer (157) covers a portion of an upper surface of the second hard mask layer (156),
wherein the second hard mask layer (156) comprises a first portion covered by the first protective layer (140) and the first hard mask layer (157) and a second portion being free from the first protective layer (140) and the first hard mask layer (157), and
wherein the second portion of the second hard mask layer (156) contacts the source electrode (173).

11. The semiconductor device of any of claims 3-10, wherein the first hard mask layer (157) and the first protective layer (140) comprise materials having different etch selectivities,
wherein the second hard mask layer (156) and the gate spacer (158) comprise materials having different etch selectivities, and
wherein the second hard mask layer (156) and the first protective layer (140) comprise materials having different etch selectivities.

12. The semiconductor device of claim 11, wherein each of the first hard mask layer (157) and the second hard mask layer (156) comprises:
an insulating material comprising at least one of silicon oxide, silicon oxynitride, silicon carbon oxynitride, or silicon nitride;
a metal material comprising at least one of titanium, titanium aluminum, tantalum, tungsten, aluminum, copper, cobalt, nickel, platinum, nickel platinum, niobium, molybdenum, ruthenium, rhodium, palladium, iridium, osmium, silver, gold, zinc, or vanadium;
a metal nitride comprising at least one of titanium nitride, tantalum nitride, titanium silicon nitride, tantalum silicon nitride, tantalum titanium nitride, titanium aluminum nitride, tantalum aluminum nitride, tungsten nitride, molybdenum nitride, niobium nitride, titanium aluminum carbonitride, or tantalum carbonitride;
a metal carbide comprising at least one of titanium carbide, tantalum carbide, tungsten carbide, niobium carbide, molybdenum carbide, or titanium aluminum carbide;
a dielectric material comprising at least one of hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate; and
a semiconductor material comprising at least one of silicon, aluminum nitride, gallium nitride, indium nitride, indium gallium nitride, aluminum gallium nitride, aluminum indium nitride, or aluminum indium gallium nitride,
wherein the gate spacer (158) comprises at least one of an insulating material comprising silicon oxide, silicon oxynitride, silicon carbon oxynitride, or silicon nitride, and
wherein the first protective layer (140) comprises at least one of an insulating material or a semiconductor material, the insulating material comprising at least one of silicon oxide, silicon oxynitride, silicon carbon oxynitride, or silicon nitride, and the semiconductor material comprising at least one of aluminum nitride, gallium nitride, indium nitride, indium gallium nitride, aluminum gallium nitride, aluminum indium nitride, or aluminum indium gallium nitride.

13. The semiconductor device of claim 12, wherein the first protective layer (140) comprises silicon nitride,
wherein the gate spacer (158) comprises silicon oxide,
wherein the first hard mask layer (157) comprises silicon nitride or metal material, and
wherein the second hard mask layer (156) comprises silicon oxide.

14. The semiconductor device of claim 12, wherein the gate spacer (158) comprises silicon oxide,
wherein the first protective layer (140) comprises silicon nitride,
wherein the first hard mask layer (157) comprises metal material, and
wherein the second hard mask layer (156) comprises silicon oxide.

15. The semiconductor device of any of claims 3-14, wherein the gate semiconductor layer (152) comprises a second barrier layer (137) on the barrier layer (132) that is between the gate structure (155) and the drain electrode (175),
wherein the second barrier layer (137) is between the barrier layer (132) and the first protective layer (140),
wherein the second barrier layer (137) is on a side surface of the second gate spacer (158b), and
wherein an upper level of the second barrier layer (137) is higher than a lower level of the gate spacer (158) and lower than an upper level of the gate spacer (158).
